# EUROPEAN PATENT APPLICATION

(11) **EP 4 700 447 A1**
(43) Date of publication of application: **25.02.2026**
(21) Application number: 25182943.8
(22) Date of filing: 16.06.2025
(51) Int. Cl.: G02B 6/30, G02B 6/124, G02B 6/42, G02B 6/12

(54) **CHIP STRUCTURE AND SEMICONDUCTOR PACKAGE INCLUDING THE SAME**

(30) Priority: 21.08.2024 KR 20240112336
(71) Applicant: Samsung Electronics Co., Ltd., Suwon-si, Gyeonggi-do 16677 (KR)
(72) Inventor: LIN, Jing Cheng, 16677 Suwon-si, Gyeonggi-do (KR); CHANG, Jung Hua, 16677 Suwon-si, Gyeonggi-do (KR)
(74) Representative: Kuhnen & Wacker Patent- und Rechtsanwaltsbüro PartG mbB

(57) **Abstract**

Provided is a chip structure (200) including a redistribution structure (210), an electronic integrated circuit chip (220) on an upper surface of the redistribution structure (210), and a photonic integrated circuit chip (230) including a first substrate (231) on an upper surface of the electronic integrated circuit chip (220) and comprising an active surface (231_A) and an inactive surface (231_UA) opposite to the active surface (231_A), a first reflector (233) on the inactive surface (231_A) of the first substrate (231), and a first wiring structure (235) on the active surface (231_A) of the first substrate (231), the first wiring structure (235) comprising a waveguide (232), a grating coupler (232_GC), and a second reflector (234), wherein a patterned surface (GC_P) of the grating coupler (232_GC) faces the redistribution structure (210). Provided is also a semiconductor package including the chip structure (200).

## Description

### BACKGROUND

Embodiments of the present disclosure relate to a chip structure and a semiconductor package, and more particularly, to a chip structure including a photonic integrated circuit chip and a semiconductor package.

The advantages of semiconductor packages are increasingly being utilized to improve the functionality of electronic devices and integrate components. In the semiconductor packages, various integrated circuits, such as memory chips or logic chips, may be mounted on a package substrate. Recently, in an environment where data traffic is increasing in data centers and communication infrastructure, research on semiconductor packages containing photonic integrated circuit chips continues.

### SUMMARY

One or more embodiments provide a chip structure with improved structural stability and durability and a semiconductor package. The invention is set out in the appended claims.

According to an aspect of one or more embodiments, there is provided a chip structure including a redistribution structure, an electronic integrated circuit chip on an upper surface of the redistribution structure, and a photonic integrated circuit chip including a first substrate on an upper surface of the electronic integrated circuit chip and comprising an active surface and an inactive surface opposite to the active surface, a first reflector on the inactive surface of the first substrate, and a first wiring structure on the active surface of the first substrate, the first wiring structure comprising a waveguide, a grating coupler, and a second reflector, wherein a patterned surface of the grating coupler faces the redistribution structure.

According to another aspect of one or more embodiments, there is provided a semiconductor package including a package substrate, a semiconductor chip on the package substrate, and a chip structure on the package substrate and spaced apart from the semiconductor chip in a horizontal direction, wherein the chip structure includes a redistribution structure, an electronic integrated circuit chip on the redistribution structure, a first molding layer on the redistribution structure and a side surface of the electronic integrated circuit chip, a photonic integrated circuit chip including a first substrate on the first molding layer and the electronic integrated circuit chip, the first substrate comprising an active surface and an inactive surface opposite to the active surface, a first reflector on the inactive surface of the first substrate, a first wiring structure on the active surface of the first substrate, the first wiring structure comprising a waveguide, a grating coupler, and a second reflector, and a protective layer on the inactive surface of the first substrate and on the first reflector, wherein a patterned surface of the grating coupler faces the redistribution structure, and wherein the second reflector is on the patterned surface of the grating coupler.

According to yet another aspect of one or more embodiments, there is provided a semiconductor package including a package substrate, a semiconductor chip on the package substrate, a chip structure on the package substrate and spaced apart from the semiconductor chip in a horizontal direction, a second molding layer on the package substrate, the semiconductor chip, and the chip structure, wherein side surfaces of the second molding layer are aligned with side surfaces of the package substrate in a vertical direction, and wherein an upper surface of the second molding layer is coplanar with an upper surface of the chip structure and an upper surface of the semiconductor chip; and an optical fiber unit on the second side surface of the chip structure, the optical fiber unit comprising an optical fiber configured to emit optical signals to a first reflector of the chip structure, wherein the chip structure includes a redistribution structure, an electronic integrated circuit chip on the redistribution structure, a first molding layer on the redistribution structure and a side surface of the electronic integrated circuit chip, a photonic integrated circuit chip including a first substrate on the first molding layer and the electronic integrated circuit chip, the first substrate comprising an active surface and an inactive surface opposite to the active surface, the first reflector on the inactive surface of the first substrate, a first wiring structure on the active surface of the first substrate, the first wiring structure comprising a waveguide, a grating coupler, and a second reflector, and a protective layer on the inactive surface of the first substrate and on the first reflector, wherein the first reflector is configured to reflect optical signals reflected from the first reflector to be incident on a non-patterned surface of the grating coupler, and wherein the second reflector is configured reflect optical signals reflected from the second reflector to be incident on the patterned surface of the grating coupler, wherein a first side surface of the chip structure is in contact with the second molding layer, wherein the second side surface of the chip structure opposite to the first side surface of the chip structure is coplanar with a second side surface the package substrate, wherein a patterned surface of the grating coupler faces the redistribution structure, wherein the second reflector is on the patterned surface of the grating coupler, and wherein an entire patterned surface of the grating coupler overlaps with the second reflector in a vertical direction.

According to yet another aspect of one or more embodiments, there is provided a method of manufacturing a semiconductor package, the method including manufacturing a chip structure, mounting the chip structure on a package substrate, and forming a second molding layer on the package substrate and the chip structure, wherein the manufacturing of the chip structure includes mounting an electronic integrated circuit chip on a carrier substrate, forming a first molding layer on the carrier substrate and the electronic integrated circuit chip, mounting the electronic integrated circuit chip and the first molding layer on the electronic integrated circuit chip such that a patterned surface of a grating coupler included in a photonic integrated circuit chip faces downward in a vertical direction, the photonic integrated circuit chip further comprising a first substrate, a first wiring structure, a waveguide, the grating coupler, and a second reflector, forming a first trench recessed inward from an upper surface of the first substrate, forming a first reflector on a side surface of the first trench, forming a protective layer on the upper surface of the first substrate and the first reflector, and removing the electronic integrated circuit chip from the carrier substrate and forming a redistribution structure on the electronic integrated circuit chip, wherein the forming the first reflector during the manufacturing of the chip structure includes forming the first reflector configured to reflect optical signals reflected from the first reflector to be incident on a non-patterned surface of the grating coupler opposite to the patterned surface of the grating coupler.

In an embodiment of the disclosure, the method further comprises, after the forming of the second molding layer, sawing the second molding layer and the package substrate to externally expose a second side surface among side surfaces of the chip structure is exposed to the outside.

In an embodiment of the disclosure, the method further comprises forming an anti-reflective layer on the second side surface of the chip structure exposed externally

In an embodiment of the disclosure, the mounting of the photonic integrated circuit chip comprising forming the second reflector on the patterned surface of the grating coupler.

### BRIEF DESCRIPTION OF DRAWINGS

Embodiments will be more clearly understood from the following detailed description taken in conjunction with the accompanying drawings in which:
FIG. 1 is a schematic plan view of a semiconductor package according to one or more embodiments;
FIG. 2 is a schematic cross-sectional view of the semiconductor package of FIG. 1, taken along line A-A' in FIG. 1;
FIG. 3 is a schematic cross-sectional view of the semiconductor package of FIG. 1, taken along line B-B' in FIG. 1;
FIG. 4 is a schematic cross-sectional view of a semiconductor package according to one or more embodiments;
FIG. 5 is a schematic cross-sectional view of a semiconductor package according to one or more embodiments;
FIG. 6 is a schematic cross-sectional view of a chip structure according to one or more embodiments;
FIG. 7 is a schematic enlarged view of a portion of the chip structure of FIG. 6;
FIG. 8 is a schematic cross-sectional view of a chip structure according to one or more embodiments;
FIGS. 9A, 9B, 9C, 9D, 9E, 9F, 9G, and 9H are diagrams illustrating a method of manufacturing a chip structure according to one or more embodiments; and
FIGS. 10A, 10B, 10C, 10D, and 10E are diagrams illustrating a method of manufacturing a semiconductor package according to one or more embodiments.

### DETAILED DESCRIPTION

Since embodiments are subject to various changes and have various forms, some embodiments may be described in detail with reference to the drawings. However, this is not intended to limit the embodiments to the specific disclosure form. Embodiments described herein are example embodiments, and thus, the disclosure is not limited thereto.

It will be understood that, although the terms first, second, third, fourth, etc. may be used herein to describe various elements, components, regions, layers and/or sections (collectively "elements"), these elements should not be limited by these terms. These terms are only used to distinguish one element from another element. Thus, a first element described in this description section may be termed a second element or vice versa in the claim section without departing from the teachings of the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

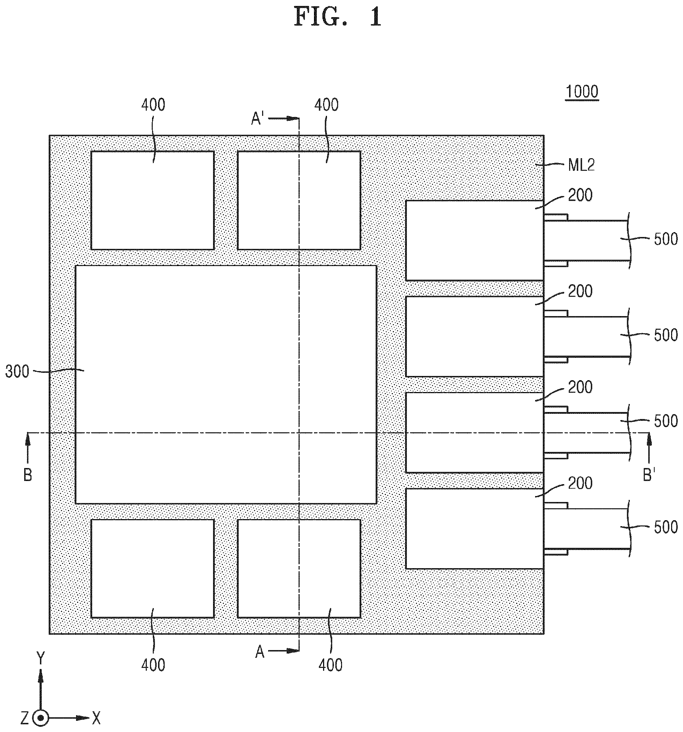

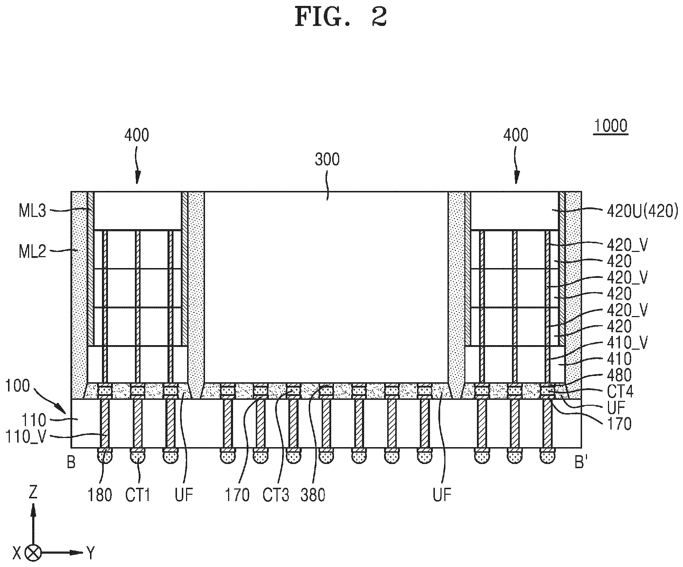

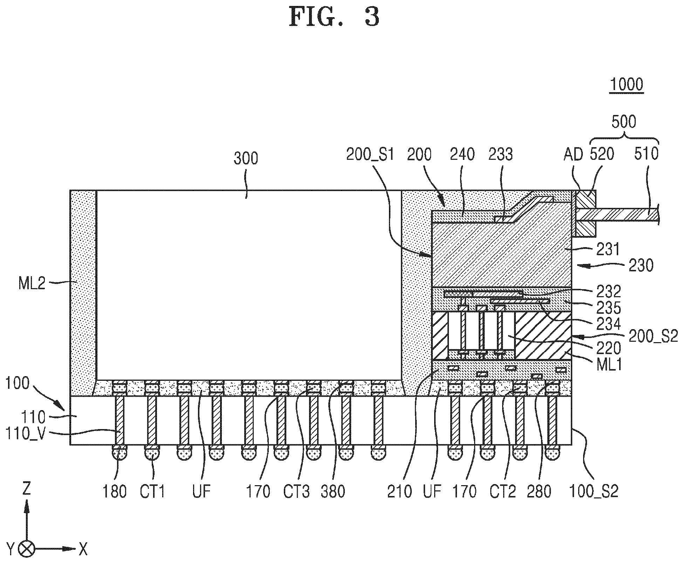

FIG. 1 is a schematic plan view of a semiconductor package 1000 according to one or more embodiments. FIG. 2 is a schematic cross-sectional view of the semiconductor package 1000 of FIG. 1, taken along line A-A' in FIG. 1. FIG. 3 is a schematic cross-sectional view of the semiconductor package 1000 of FIG. 1, taken along line B-B' in FIG. 1.

Referring to FIGS. 1 to 3, the semiconductor package 1000 may include a package substrate 100, a semiconductor chip 300, a chip structure 200, and a second molding layer ML2.

In one or more embodiments, the semiconductor package 1000 may further include a stacked structure 400. In FIG. 1, the semiconductor package 1000 is shown to include one semiconductor chip 300 and four stacked structures 400, but the number of semiconductor chips 300 and the number of stacked structures 400, each included in the semiconductor package 1000, are not limited thereto. For example, the semiconductor package 1000 may include only one of the semiconductor chip 300 and the stacked structure 400.

Hereinafter, unless specifically defined, a direction parallel to an upper surface of the package substrate 100 is defined as a first horizontal direction (X direction), a direction perpendicular to the upper surface of the package substrate 100 is defined as a vertical direction (Z direction), and a direction perpendicular to the first horizontal direction (X direction) and the vertical direction (Z direction) is defined as a second horizontal direction (Y direction). A horizontal direction is defined as a combination of the first horizontal direction (X direction) and the second horizontal direction (Y direction).

The package substrate 100 may include an interposer including a substrate 110 and through vias 110_V passing through the substrate 110. For example, the package substrate 100 may include a glass interposer in which the substrate 110 includes glass and the through vias 110_V include through glass vias (TGVs). However, embodiments are not limited thereto. For example, the package substrate 100 may include a silicon interposer in which the substrate 110 includes silicon (Si) and the through vias 110_V include through silicon vias (TSVs).

In one or more embodiments, the package substrate 100 may include a printed circuit board (PCB) including a core insulating layer including at least one of phenol resin, epoxy resin, and polyimide.

In one or more embodiments, the package substrate 100 may further include upper pads 170 located on an upper surface of the substrate 110 and lower pads 180 located on a lower surface of the substrate 110. The upper pads 170 and the lower pads 180 may be electrically connected to each other by the through vias 110_V or internal wiring. For example, the upper pads 170 and the lower pads 180 may each include, for example, copper (Cu), nickel (Ni), stainless steel, or beryllium copper (BeCu).

In one or more embodiments, connection terminals CT1 may be respectively attached to the lower pads 180 of the package substrate 100. The connection terminals CT1 may be configured to electrically and physically connect the package substrate 100 to an external device on which the package substrate 100 is mounted. The connection terminals CT1 may be formed, for example, from solder balls or solder bumps.

The semiconductor chip 300 may be located on and above the package substrate 100 in the vertical (Z direction). The semiconductor chip 300 may include an active surface and an inactive surface opposite to the active surface. In one or more embodiments, the semiconductor chip 300 may include an application specific integrated circuit (ASIC).

In one or more embodiments, the semiconductor chip 300 may be mounted on the package substrate 100 so that the active surface of the semiconductor chip 300 faces the package substrate 100. For example, the semiconductor chip 300 may be placed above the package substrate 100 in a face down manner.

In one or more embodiments, a plurality of individual devices of various kinds may be located on the active surface of the semiconductor chip 300. For example, the plurality of individual devices may include various microelectronic devices, for example, a complementary metal-oxide semiconductor (CMOS) transistor, a metal-oxide-semiconductor field effect transistor (MOSFET), an image sensor, such as system large scale integration (LSI) and a CMOS imaging sensor (CIS), a micro-electro-mechanical system (MEMS), an active device, and a passive device.

In one or more embodiments, the semiconductor chip 300 may further include lower pads 380 formed on a lower surface of the semiconductor chip 300. For example, the lower pads 380 of the semiconductor chip 300 may be electrically connected to a wiring structure formed on the active surface of the semiconductor chip 300.

The lower pads 380 of the semiconductor chip 300 may be electrically connected to the package substrate 100 by connection terminals CT3. The connection terminals CT3 may be formed, for example, from solder balls or solder bumps. However, embodiments are not limited thereto. The lower pads 380 of the semiconductor chip 300 may be electrically connected to the package substrate 100 by, for example, direct bonding or hybrid bonding.

Above the package substrate 100, the stacked structure 400 may be spaced apart from the semiconductor chip 300 in the horizontal direction. A plurality of stacked structures 400 may be located above the package substrate 100 in the vertical direction (Z direction). For example, the stacked structures 400 may be provided on the package substrate 100 and surround the semiconductor chip 300. For example, the stacked structures 400 may be placed on both sides of the semiconductor chip 300. The stacked structures 400 may be electrically connected to the semiconductor chip 300 through the package substrate 100.

The stacked structure 400 may include a buffer chip 410, a plurality of core chips 420, and a core molding layer ML3. The buffer chip 410 may be located at the bottom of the stacked structure 400, and the plurality of core chips 420 may be stacked on the buffer chip 410 in the vertical direction (Z direction). The core molding layer ML3 may be located on a side surface of the buffer chip 410 in the horizontal direction, and may be provided on and surround the plurality of core chips 420.

For example, an upper surface of the core molding layer ML3 may be coplanar with an upper surface of an uppermost core chip 420U. Accordingly, the upper surface of the uppermost core chip 420U may be exposed to the outside.

The buffer chip 410 and the plurality of core chips 420 may each include, for example, a semiconductor material, such as Si or germanium (Ge). As another example, the buffer chip 410 and the plurality of core chips 420 may each include a compound semiconductor material, such as silicon carbide (SiC), gallium arsenide (GaAs), indium arsenide (InAs), and indium phosphide (InP).

The buffer chip 410 and the plurality of core chips 420 may each include an active surface and an inactive surface opposite to the active surface. A semiconductor device including a plurality of individual devices of various kinds may be formed on the active surface of each of the buffer chip 410 and the plurality of core chips 420.

Each of the buffer chip 410 and the plurality of core chips 420 may include a well doped with impurities, which is a conductive region. Each of the buffer chip 410 and the plurality of core chips 420 may have various device isolation structures, such as, for example, a shallow trench isolation (STI) structure.

The plurality of individual devices of the buffer chip 410 may include various microelectronic devices, for example, a MOSFET, such as a CMOS transistor, an image sensor, such as system LSI and a CIS, an MEMS, an active device, a passive device, and the like.

The plurality of individual devices of each of the plurality of core chips 420 may include a memory cell. For example, the memory cell may include a non-volatile memory cell, such as flash memory, phase-change random-access memory (PRAM), magnetoresistive random-access memory (MRAM), ferroelectric random-access memory (FeRAM), or resistive random-access memory (RRAM). In one or more embodiments, the memory cell may include a volatile memory cell, such as dynamic random-access memory (DRAM) or static random-access memory (SRAM).

The plurality of individual devices of the buffer chip 410 may be electrically connected to the conductive region of the buffer chip 410 and the plurality of individual devices of each of the plurality of core chips 420 may be electrically connected to the conductive region of each of the plurality of core chips 420.

In one or more embodiments, the buffer chip 410 including a serial-parallel conversion circuit may include a semiconductor chip for controlling the plurality of core chips 420, and the plurality of core chips 420 may each include a memory chip including memory cells. For example, the stacked structure 400 including the buffer chip 410 and the plurality of core chips 420 may include high bandwidth memory (HBM). The buffer chip 410 may be referred to as an HBM control die, and each of the plurality of core chips 420 may be referred to as a DRAM die.

In one or more embodiments, a core chip located at the top of the stacked structure 400, among the plurality of core chips 420, may be referred to as uppermost core chip 420U. In FIG. 2, each of the plurality of stacked structures 400 is shown to include four core chips 420 stacked, but the number of core chips 420 included in each of the plurality of stacked structures 400 is not limited thereto.

In one or more embodiments, among the plurality of core chips 420, core chips 420 excluding the uppermost core chip 420U may further include through vias 420_V extending inward from upper surfaces of the core chips 420 to the bottom surfaces of the core chips 420. The through vias 420_V of each of the core chips 420 excluding the uppermost core chip 420U may be electrically connected to a conductive region of each of the core chips 420. However, embodiments are not limited thereto. The uppermost core chip 420U may also include through vias 420_V.

Each of the plurality of core chips 420 may be electrically connected to another adjacent core chip 420 or the buffer chip 410 by the through vias 420_V. Accordingly, the plurality of core chips 420 may be electrically connected to the package substrate 100 through the through vias 420_V. For example, the conductive region of the uppermost core chip 420U may be electrically connected to the package substrate 100 through the through vias 420_V of the core chips 420 stacked below the uppermost core chip 420U in the vertical direction (Z direction).

In one or more embodiments, a thickness of each of the plurality of core chips 420, that is, a length of each of the plurality of core chips 420 in the vertical direction (Z direction), may be about 20 µm to about 80 µm. The thicknesses of the plurality of core chips 420 may have substantially the same value.

In one or more embodiments, lower pads 480 may be located on a lower surface of the buffer chip 410. The lower pads 480 of the buffer chip 410 may be electrically connected to the through vias 410_V of the buffer chip 410 or a wiring structure of the buffer chip 410.

The lower pads 480 of the buffer chip 410 may be electrically connected to the upper pads 170 of the package substrate 100 by connection terminals CT4. The connection terminals CT4 may be formed, for example, from solder balls or solder bumps. However, embodiments are not limited thereto. The lower pads 480 of the buffer chip 410 may be electrically connected to the package substrate 100 by, for example, direct bonding or hybrid bonding.

The chip structure 200 may be located above the package substrate 100. The chip structure 200 may be spaced apart from the semiconductor chip 300 and the stacked structures 400 in the horizontal direction. In one or more embodiments, the semiconductor chip 300 may be located in a center region of the package substrate 100, and the chip structures 200 and the stacked structures 400 may be located in an edge region of the package substrate 100. In FIG. 1, the number of chip structures 200 and the number of stacked structures 400 are the same, but the number of chip structures 200 is not limited thereto.

The chip structure 200 may include a redistribution structure 210, an electronic integrated circuit (EIC) chip 220, and a photonic integrated circuit (PIC) chip 230. The semiconductor package 1000 may transmit and receive optical signals to and from an external device through the chip structures 200.

The redistribution structure 210 may be located at the bottom of the chip structure 200 and may connect an EIC chip 220 and a PIC chip 230 of the chip structure 200 to the package substrate 100. For example, lower pads 280 of the redistribution structure 210 may be connected to the upper pads 170 of the package substrate 100 through connection terminals CT2, respectively. The connection terminals CT2 may be formed, for example, from solder balls or solder bumps.

However, embodiments are not limited thereto. The lower pads 280 of the redistribution structure 210 may be electrically connected to the package substrate 100 by, for example, direct bonding or hybrid bonding.

The PIC chip 230 may be configured to convert optical signals into electrical signals and convert electrical signals into optical signals. The EIC chip 220 may be configured to interconnect the PIC chip 230 with the semiconductor chip 300. For example, the EIC chip 220 may convert electrical signals converted by the PIC chip 230 to match the semiconductor chip 300 or the stacked structures 400.

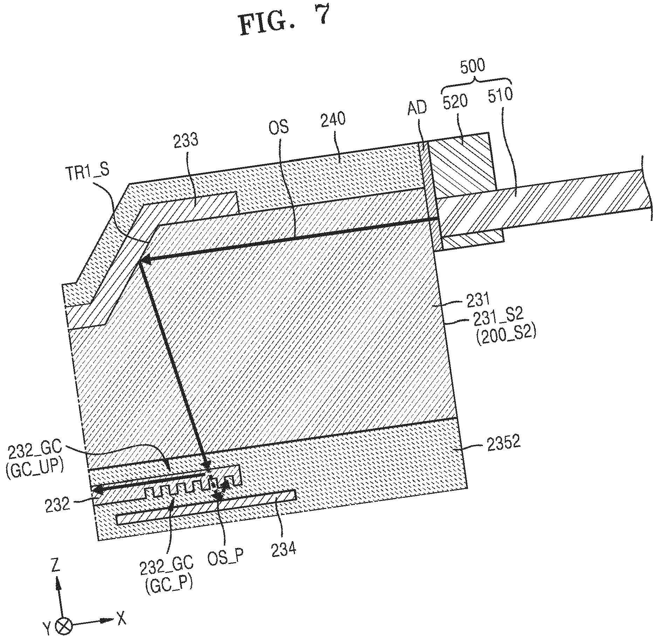

The PIC chip 230 of the chip structure 200 may further include a first reflector 233 and a second reflector 234. In one or more embodiments, the first reflector 233 may be configured so that optical signals OS (see FIG. 7) reflected from the first reflector 233 are incident on a non-patterned surface GC_UP (see FIG. 7) of a grating coupler 232_GC (see FIG. 7). The second reflector 234 may be configured so that optical signals OS (see FIG. 7) reflected from the second reflector 234 are incident on a patterned surface GC_P (see FIG. 7) of the grating coupler 232_GC (see FIG. 7).

In one or more embodiments, the chip structure 200 may include a first side surface 200_S1 and a second side surface 200_S2 opposite the first side surface 200_S1. The first side surface 200_S1 of the chip structure 200 may be in contact with the second molding layer ML2. The second side surface 200_S2 of the chip structure 200 may be coplanar with a second side surface 100_S2 of the package substrate 100.

The second side surface 200_S2 of the chip structure 200 may be exposed to the outside of the semiconductor package 1000. An optical fiber unit 500 may be located on the second side surface 200_S2 of the chip structure 200. For example, by cutting part of the package substrate 100 and the second molding layer ML2 along the second side surface 200_S2 of the chip structure 200, the second side surface 200_S2 of the chip structure 200 may be coplanar with the second side surface 100_S2 of the package substrate 100.

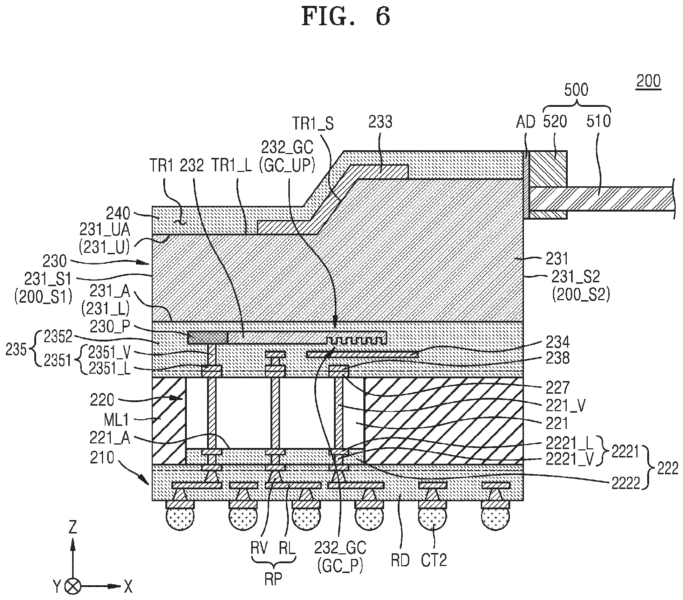

The chip structure 200 may be described in detail below with reference to FIGS. 6 to 8.

The semiconductor package 1000 may further include an underfill layer UF. The underfill layer UF may be located between the package substrate 100 and semiconductor chip 300, between the package substrate 100 and the stacked structure 400, and between the package substrate 100 and the chip structure 200. The underfill layer UF may be provided on and cover the connection terminals CT2, CT3, and CT4 located on the upper surface of the package substrate 100. For example, the underfill layer UF may protect the connection terminals CT2, CT3, and CT4 from external shock.

The second molding layer ML2 may be located on the package substrate 100. The second molding layer ML2 may be provided on and cover at least part of the side surfaces of the semiconductor chip 300, the stacked structure 400, and the chip structure 200. For example, one side surface of the second molding layer ML2 may be coplanar with the side surface of the package substrate 100. For example, one side surface of the second molding layer ML2 may be coplanar with the second side surface 200_S2 of the chip structure 200. The second side surface 200_S2 of the chip structure 200 may not be covered by the second molding layer ML2 and may be exposed to the outside.

In one or more embodiments, an upper surface of the second molding layer ML2 may be coplanar with an upper surface of the chip structure 200, an upper surface of the semiconductor chip 300, and an upper surface of the stacked structure 400. For example, the top surface of the chip structure 200 may be exposed to the outside of the second molding layer ML2.

In one or more embodiments, there may be an interface between the second molding layer ML2 and the core molding layer ML3 of the stacked structure 400. There may be an interface between the second molding layer ML2 and a first molding layer ML1 of the chip structure 200.

For example, as the second molding layer ML2 is formed after mounting the stacked structure 400 and the chip structure 200 on the package substrate 100, there is a difference in curing time between the core molding layer ML3, the first molding layer ML1, and the second molding layer ML2. Thus, there may be an interface between the core molding layer ML3 and the second molding layer ML2 and between the first molding layer ML1 and the second molding layer ML2.

For example, the second molding layer ML2 may include epoxy resin or polyimide resin. The second molding layer ML2, for example, may include epoxy molding compound (EMC).

The semiconductor package 1000 may further include the optical fiber unit 500. The optical fiber unit 500 may include a frame 520 and an optical fiber 510 fixed to the frame 520. The optical fiber 510 may provide a path along which the optical signals OS (see FIG. 7) move. For example, the optical fiber unit 500 may include a plurality of optical fibers 510. The plurality of optical fibers 510 may be arranged in the horizontal direction.

The optical fiber unit 500 may be located on the second side surface 200_S2 of the chip structure 200. In one or more embodiments, the optical fiber unit 500 may be attached to the second side surface 200_S2 of the chip structure 200 and configured to transmit the optical signals OS (see FIG. 7) emitted from the optical fiber 510 of the optical fiber unit 500 to be incident on the first reflector 233.

In one or more embodiments, the frame 520 of the optical fiber unit 500 may be attached to the second side surface 200_S2 of the chip structure 200 by an optical adhesive film AD. In one or more embodiments, the optical adhesive film AD may include, for example, transparent epoxy.

The path of the optical signals OS (see FIG. 7) emitted from the optical fiber 510 of the optical fiber unit 500 may be changed by the first reflector 233 and the second reflector 234 of the chip structure 200. Accordingly, although the optical fiber unit 500 is attached to the second side surface 200_S2 of the chip structure 200, the optical signals OS (see FIG. 7) emitted from the optical fiber 510 may be input to the PIC chip 230 of the chip structure 200. Accordingly, as the optical fiber unit 500 is attached to the second side surface 200_S2 of the chip structure 200, a length of the semiconductor package 1000 in the vertical direction (Z direction) may be relatively reduced.

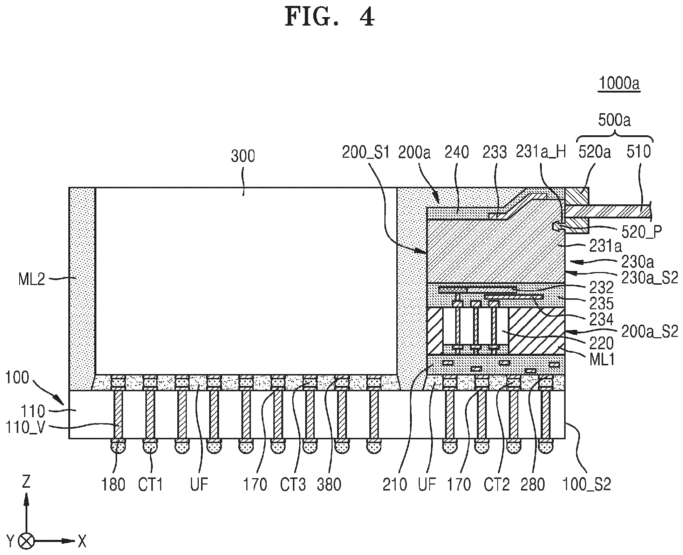

FIG. 4 is a schematic cross-sectional view of a semiconductor package 1000a according to one or more embodiments.

Most of the components that form the semiconductor package 1000a to be described below and the materials that make up the components are substantially the same as or similar to those described above with reference to FIG. 3. Therefore, for convenience of explanation, differences between the semiconductor package 1000a of FIG. 4 and the semiconductor package 1000 of FIG. 3 described above may be mainly described.

Referring to FIG. 4, the semiconductor package 1000a may include a package substrate 100, a semiconductor chip 300, and a chip structure 200a. For example, the semiconductor package 1000a may further include stacked structures 400 (see FIG. 1).

The chip structure 200a may include a redistribution structure 210, an EIC chip 220, and a PIC chip 230a. The PIC chip 230a may include a first substrate 231a including an active surface and an inactive surface, a first reflector 233, a second reflector 234, and a grating coupler 232_GC (see FIG. 7).

A second side surface 200a_S2 of the chip structure 200a may be coplanar with the second side surface 100_S2 of the package substrate 100. For example, the second side surface 200a_S2 of the chip structure 200a may be exposed to the outside of the semiconductor package 1000a. The second side surface 230a_S2 of the PIC chip 230a of the chip structure 200a may be included in the second side surface 200a_S2 of the chip structure 200a. The second side surface 230a_S2 of the PIC chip 230a may be coplanar with the second side surface 100_S2 of the package substrate 100. The second side surface 230a_S2 of the PIC chip 230a may be exposed to the outside of the semiconductor package 1000a.

In one or more embodiments, the PIC chip 230a may further include an inner groove 231a_H. For example, the inner groove 231a_H of the PIC chip 230a may extend inward into the PIC chip 230a from the second side surface 230a_S2 of the PIC chip 230a.

The optical fiber unit 500a may be coupled to the second side surface 200a_S2 of the chip structure 200a. The optical fiber unit 500a may be detachably coupled to the chip structure 200a. For example, the optical fiber unit 500a may be detachably coupled to the PIC chip 230a of the chip structure 200a.

The optical fiber unit 500a may include a frame 520a and an optical fiber 510 fixed to the frame 520a. For example, optical signals emitted from the optical fiber 510 of the optical fiber unit 500a may be incident on the first reflector 233 of the PIC chip 230a. For example, the optical signals emitted from the optical fiber 510 may be reflected from the first reflector 233 and may be incident on the grating coupler 232_GC (see FIG. 6) of the PIC chip 230a.

In one or more embodiments, the frame 520a of the optical fiber unit 500a may further include a coupling hook 520_P. For example, the coupling hook 520_P of the frame 520a and the inner groove 231a_H of the PIC chip 230a may be configured so that the coupling hook 520_P of the frame 520 is inserted into the inner groove 231a_H of the PIC chip 230a.

For example, the frame 520a of the optical fiber unit 500a may be detachably coupled to the chip structure 200a in a snap-fit manner. For example, by using the elasticity of the coupling hook 520_P, the coupling hook 520_P may be inserted into the inner groove 231a_H or the coupling hook 520_P may be separated from the inner groove 231a_H.

In one or more embodiments, the optical fiber unit 500a may further include a control button that allows a user to apply pressure to control the movement of the coupling hook 520_P. The user may separate the frame 520a of the optical fiber unit 500a from the PIC chip 230a of the chip structure 200a by separating the coupling hook 520_P from the inner groove 231a_H through the control button.

However, embodiments are not limited thereto. A method by which the optical fiber unit 500a is detachably coupled to the chip structure 200a is not limited to the above. The optical fiber unit 500a may be detachably coupled to the chip structure 200a in various known ways.

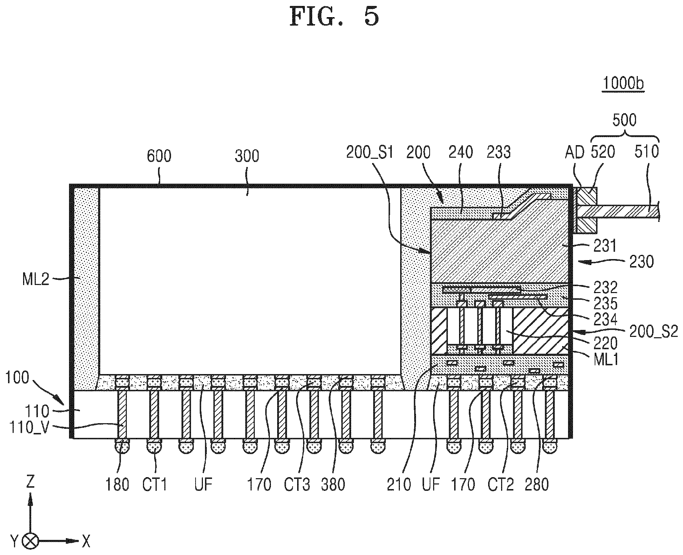

FIG. 5 is a schematic cross-sectional view of a semiconductor package 1000b according to one or more embodiments.

Most of the components that form the semiconductor package 1000b to be described below and the materials that make up the components are substantially the same as or similar to those described above with reference to FIG. 3. Therefore, for convenience of explanation, differences between the semiconductor package 1000b of FIG. 5 and the semiconductor package 1000 of FIG. 3 described above may be mainly described.

The semiconductor package 1000b may include a package substrate 100, a semiconductor chip 300, a chip structure 200, and an anti-reflective layer 600. For example, the semiconductor package 1000b may further include stacked structures 400 (see FIG. 1). In one or more embodiments, the semiconductor package 1000b may include only one of the semiconductor chip 300 and the stacked structure 400 (see FIG. 1).

A portion of the anti-reflective layer 600 may be located on the second side surface 200_S2 of the chip structure 200. In one or more embodiments, the anti-reflective layer 600 may be provided on and cover an outer surface of the second molding layer ML2 and the second side surface 200_S2 of the chip structure 200. For example, the anti-reflective layer 600 may be formed by depositing an anti-reflective material on the outer surface of the semiconductor package 1000 (see FIG. 2) of FIG. 2. In one or more embodiments, the anti-reflective layer 600 may be formed by chemical vapor deposition.

a refractive index of the anti-reflective layer 600 may be between the refractive index of Si and a refractive index of glass. For example, the refractive index of the anti-reflective layer 600 may be between a refractive index of the first substrate 231 and a refractive index of a core layer of the optical fiber 510. For example, the refractive index of the anti-reflective layer 600 may be about 1.5 to about 3.4.

The optical fiber unit 500 may be attached to the second side surface 200_S2 of the chip structure 200. The second side surface 200_S2 of the chip structure 200 may be coplanar with the second side surface 100_S2 (see FIG. 2) of the package substrate 100. A portion of the anti-reflective layer 600 may be formed on the second side surface 200_S2 of the chip structure 200. A portion of the anti-reflective layer 600 may be located between the optical fiber 510 of the optical fiber unit 500 and the chip structure 200.

In one or more embodiments, the anti-reflective layer 600 may have a multilayer structure. In one or more embodiments, the anti-reflective layer 600 may include at least one of, for example, silicon dioxide, silicon nitride, titanium dioxide, aluminum oxide, and magnesium fluoride.

FIG. 6 is a schematic cross-sectional view of a chip structure 200 according to one or more embodiments. FIG. 7 is a schematic enlarged view of a portion of the chip structure 200 of FIG. 6.

Referring to FIGS. 6 and 7, the chip structure 200 may include a redistribution structure 210, an EIC chip 220, a first molding layer ML1, a PIC chip 230, and a protective layer 240. The chip structure 200 described above may be described in more detail with reference to FIGS. 6 and 7.

The redistribution structure 210 may include redistribution patterns RP and a redistribution insulating layer RD provided on and surrounding the redistribution patterns RP. The redistribution insulating layer RD may include an insulating material, for example, photo-imageable dielectric (PID) resin or silicon oxide. In one or more embodiments, the redistribution insulating layer RD may further include an inorganic filler. In one or more embodiments, the redistribution insulating layer RD may have a multi-layer structure in which the redistribution patterns RP are arranged in each layer.

The redistribution patterns RP may include a redistribution line RL extending in the horizontal direction and a redistribution via RV extending from the redistribution line RL in the vertical direction (Z direction). The redistribution line RL may be arranged on at least one of the upper surface and the lower surface of the redistribution insulating layer RD or inside the redistribution insulating layer RD. The redistribution via RV may pass through the redistribution insulating layer RD to connect to a portion of the redistribution line RL.

The redistribution patterns RP may include conductive materials, for example, Cu, aluminum (Al), silver (Ag), tin (Sn), gold (Au), Ni, lead (Pb), titanium (Ti), or alloys thereof.

In one or more embodiments, as a distance between the redistribution via RV and the EIC chip 220 decreases, a width of the redistribution via RV in the first horizontal direction (X direction) and/or a width of the redistribution via RV in the second horizontal direction (Y direction) may decrease. For example, as the distance between the redistribution via RV and the EIC chip 220 decreases, a horizontal area of the redistribution via RV may decrease.

The EIC chip 220 may be located on an upper surface of the redistribution structure 210. The EIC chip 220 may be configured to interconnect the PIC chip 230 with the semiconductor chip 300 (see FIG. 1) or the stacked structure 400 (see FIG. 1). For example, the EIC chip 220 may convert the electrical signals converted by the PIC chip 230 to match the semiconductor chip 300 (see FIG. 1) or the stacked structure 400 (see FIG. 1).

In one or more embodiments, the area of the EIC chip 220 may be less than an area of the redistribution structure 210. For example, a side surface of the EIC chip 220 may be located on the upper surface of the redistribution structure 210. A portion of the redistribution structure 210 may not be covered by the EIC chip 220.

The EIC chip 220 may include a second substrate 221, second through vias 221_V, and a second wiring structure 222. The second substrate 221 of the EIC chip 220 may include an active surface 221_A and an inactive surface opposite to the active surface. The second wiring structure 222 may be formed on the active surface 221_A of the second substrate 221. The second through vias 221_V may extend from the inactive surface of the second substrate 221 to the active surface 221_A of the second substrate 221. The second through vias 221_V may be electrically connected to the second wiring structure 222 and/or a plurality of individual devices on the active surface 221_A of the second substrate 221.

In one or more embodiments, the second substrate 221 may include a semiconductor material, such as Si. As another example, the second substrate 221 may include a semiconductor material, such as Ge.

In one or more embodiments, the EIC chip 220 may include a plurality of individual devices used to interconnect the PIC chip 230 with the semiconductor chip 300 (see FIG. 1). The plurality of individual devices of the EIC chip 220 may be located on the active surface 221_A of the second substrate 221. For example, the EIC chip 220 may include CMOS drivers and transimpedance amplifiers to perform functions, such as controlling high-frequency signaling of the PIC chip 230.

The second wiring structure 222 may include second wiring patterns 2221 and a second wiring insulating layer 2222 provided on and surrounding the second wiring patterns 2221. The second wiring pattern 2221 may include a second wiring line 2221_L extending in the horizontal direction and a second wiring via 2221_V extending from the second wiring line 2221_L in the vertical direction (Z direction). The second wiring patterns 2221 may be electrically connected to the plurality of individual devices and the redistribution structure 210.

In one or more embodiments, the EIC chip 220 may be placed on the redistribution structure 210 so that the active surface 221_A of the second substrate 221 faces the redistribution structure 210. For example, the EIC chip 220 may be placed on the redistribution structure 210 in a face down manner. However, embodiments are not limited thereto. The EIC chip 220 may be placed on the redistribution structure 210 in a face-up manner.

The EIC chip 220 may further include upper pads 227. In one or more embodiments, an upper pad 227 may form one body with a second through via 221_V of the EIC chip 220. The upper pad 227 may be electrically connected to the second wiring structure 222 of the EIC chip 220 through the second through via 221_V.

In FIG. 6, it is shown that the upper pad 227 forms one body with the second through via 221_V, but is not limited thereto. The upper pad 227 may be spaced apart from the second through via 221_V as a wiring structure is located on the upper surface of the EIC chip 220.

The first molding layer ML1 may be located between the redistribution structure 210 and the PIC chip 230, and may be provided on and surround the EIC chip 220. The first molding layer ML1 may be provided on cover side surfaces of the EIC chip 220. For example, a side surface of the first molding layer ML1 may be coplanar with a side surface of the PIC chip 230. For example, the sum of an area of a lower surface of the EIC chip 220 and an area of a lower surface of the first molding layer ML 1 may be equal to an area of the upper surface of the redistribution structure 210.

For example, the first molding layer ML1 may include epoxy resin or polyimide resin. The first molding layer ML1, for example, may include EMC.

The PIC chip 230 may be located on the upper surface of the EIC chip 220. For example, the PIC chip 230 may be located on the EIC chip 220 and the first molding layer ML1. In one or more embodiments, an area of the lower surface of the EIC chip 220 may be less than an area of the lower surface of the PIC chip 230. For example, the area of the lower surface of the EIC chip 220 may be about 20% to about 50% of the area of the lower surface of the PIC chip 230.

The PIC chip 230 may include a first substrate 231, a first wiring structure 235, a waveguide 232, a grating coupler 232_GC, an optical component 230_P, a first reflector 233, and a second reflector 234.

The first substrate 231 may include an active surface 231_A and an inactive surface 231_UA opposite to the active surface 231_A. The active surface 231_A of the first substrate 231 may include a surface, of the outer surface of the first substrate 231, on which the waveguide 232 and the optical component 230_P are formed. For example, a surface, of the outer surface of the first substrate 231, on which the optical component 230_P including individual devices configured to convert optical signals into electrical signals or convert electrical signals into optical signals is formed may be referred to as the active surface 231_A of the first substrate 231. In one or more embodiments, the first substrate 231 may include Si. For example, the first substrate 231 may be referred to as a Si substrate.

For example, the PIC chip 230 may be placed on the EIC chip 220 so that the active surface 231_A of the first substrate 231 faces the EIC chip 220. The active surface 23 1_A of the first substrate 231 may include a lower surface 23 1_L of the first substrate 231, and the inactive surface 231_UA of the first substrate 231 may include an upper surface 231_U of the first substrate 231.

In one or more embodiments, the first substrate 231 may include a first trench TR1. The first trench TR1 may be recessed inward from the upper surface 231_U and a first side surface 231_S1 of the first substrate 231. The first side surface 23 1_S1 of the first substrate 231 may be included in the first side surface 200_S1 of the chip structure 200. For example, the first side surface 231_S1 of the first substrate 231 may be opposite to the second side surface 231_S2 of the first substrate 231 exposed to the outside. For example, based on FIG. 3, the first side surface 231_S1 of the first substrate 231 may be in contact with the second molding layer ML2 (see FIG. 2).

A portion of the upper surface 231_U of the first substrate 231 may define a side surface TR1_S of the first trench TR1 and a portion of the upper surface of the first substrate 231 may define a bottom TR1_L of the first trench TR1. In one or more embodiments, the first trench TR1 of the first substrate 231 may be formed by removing a portion of the first substrate 231 through an etching process. A non-recessed portion of the upper surface 231_U of the first substrate 231 may be referred to as a top surface of the first substrate 231.

In one or more embodiments, an angle formed between the bottom TR1_L of the first trench TR1 and the side surface TR1_S of the first trench TR1 may include an obtuse angle. In one or more embodiments, the angle formed by the bottom TR1_L of the first trench TR1 and the side surface TR1_S of the first trench TR1 may be about 110 degrees to about 150 degrees. For example, as the side surface TR1_S of the first trench TR1 extends downward in the vertical direction (Z direction), the distance between the side surface TR1_S of the first trench TR1 and the second side surface 200_S2 of the chip structure 200 may increase.

The first reflector 233 may be located on the inactive surface 231_UA of the first substrate 231. For example, the first reflector 233 may be provided on and cover the side surface TR1_S of the first trench TR1 of the first substrate 231. In one or more embodiments, the first reflector 233 may not completely be provided on and cover the inactive surface 231_UA of the first substrate 231. For example, part of the upper surface of the first substrate 231 may not contact the first reflector 233.

The first reflector 233 may be configured so that the optical signals OS reflected from the first reflector 233 are incident on the non-patterned surface GC_UP of the grating coupler 232_GC located on the active surface 231_A of the first substrate 231. For example, the path through which the optical signals OS are reflected from the first reflector 233 may vary depending on the angle at which the side surface TR1_S of the first trench TR1 is inclined. Accordingly, the angle at which the side surface TR1_S of the first trench TR1 is inclined may vary depending on the position of the grating coupler 232_GC of the PIC chip 230.

In one or more embodiments, when the grating coupler 232_GC is located below the bottom TR1_L of the first trench TR1 on the upper surface 231_U of the first substrate 231, the angle at which the side surface TR1_S of the first trench TR1 is inclined may be relatively small. In one or more embodiments, when the grating coupler 232_GC is not located below the bottom TR1_L of the first trench TR1 on the upper surface the first substrate 231, the angle at which the side surface TR1_S of the first trench TR1 is inclined may be relatively large.

In one or more embodiments, the optical signals OS emitted from the optical fiber 510 of the optical fiber unit 500 may be emitted toward the side surface TR1_S of the first trench TR1 of the first substrate 231. The optical signals OS incident on the side surface TR1_S of the first trench TR1 may be reflected by the first reflector 233. For example, the optical signals OS reflected from the first reflector 233 may pass through the first substrate 231 and reach the grating coupler 232_GC.

In one or more embodiments, the first reflector 233 may include Cu, Al, Ag, Sn, Au, Ni, Pb, Ti, or alloys thereof.

In one or more embodiments, the chip structure 200 may further include a protective layer 240. The protective layer 240 may be located on the inactive surface 231_UA of the first substrate 231. The protective layer 240 may be provided on and cover the first reflector 233. For example, the protective layer 240 may be conformally formed on the upper surface 231_U of the first substrate 231. For example, the protective layer 240 may be formed in a "Z" shape corresponding to a shape of the first trench TR1 of the first substrate 231.

In one or more embodiments, the protective layer 240 may include silicon oxide and silicon nitride. For example, the protective layer 240 may protect the first reflector 233 from external shock. In one or more embodiments, the refractive index of the protective layer 240 may be less than the refractive index of the first substrate 231.

The first wiring structure 235 may be located on the active surface 231_A of the first substrate 231. For example, the first wiring structure 235 may be located between the first substrate 231 and the EIC chip 220.

The first wiring structure 235 may include first wiring patterns 2351 and a first wiring insulating layer 2352 provided on and surrounding the first wiring patterns 2351. The first wiring pattern 2351 may include a first wiring line 2351_L extending in the horizontal direction and a first wiring via 235 1_V extending from the first wiring line 2351_L in the vertical direction (Z direction). The first wiring patterns 2351 may be electrically connected to individual devices of the optical component 230_P.

The first wiring patterns 2351, the waveguide 232, the grating coupler 232_GC, the optical component 230_P, and the second reflector 234 may be located within the first wiring insulating layer 2352. The side surfaces of the first wiring insulating layer 2352 may be aligned with the side surfaces of the first substrate 231, respectively, in the vertical direction (Z direction). The upper surface of the first wiring insulating layer 2352 may be completely covered by the first substrate 231. For example, the entire upper surface of the first wiring insulating layer 2352 may be in contact with the first substrate 231 and may not be exposed to the outside. A refractive index of the first wiring insulating layer 2352 may be less than a refractive index of the waveguide 232.

In one or more embodiments, the PIC chip 230 may be placed on the EIC chip 220 so that the active surface 231_A of the first substrate 231 faces the EIC chip 220. For example, the PIC chip 230 may be placed on the EIC chip 220 in a face down manner.

For example, the PIC chip 230 may be combined with the EIC chip 220 through hybrid bonding. For example, lower pads 238 located at the bottom of the first wiring structure 235 of the PIC chip 230 may be diffusion bonded with the upper pads 227 connected to the second through vias 221_V of the EIC chip 220, respectively, by heat to form one body.

For example, in the process of diffusion bonding of the upper pads 227 of the EIC chip 220 with the lower pads 238 of the PIC chip 230, an insulating layer provided on and surrounding the upper pads 227 of the EIC chip 220 may be diffusion bonded with the first wiring insulating layer 2352 of the PIC chip 230 to form one body.

The optical component 230_P of the PIC chip 230 may be electrically connected to the EIC chip 220 through the first wiring structure 235 of the PIC chip 230. For example, the PIC chip 230 may be electrically connected to the EIC chip 220 without a through via that passes through the first substrate 231. Accordingly, a length of the first substrate 231 of the PIC chip 230 may increase in the vertical direction (Z direction). For example, the length of the first substrate 231 of the PIC chip 230 in the vertical direction (Z direction) may be about 300 µm to about 800 µm. A thickness of the PIC chip 230 may increase in the vertical direction (Z direction), thereby improving durability and increasing structural stability.

The waveguide 232 may be located on the active surface 231_A of the first substrate 231. The waveguide 232, which is a patterned silicon layer, may extend in the horizontal direction within the first wiring insulating layer 2352. For example, the waveguide 232 may be embedded in the first wiring insulating layer 2352. For example, the PIC chip 230 may include a chip in which the waveguide 232, the grating coupler 232_GC, the optical component 230_P, and the first wiring structure 235 are formed on a silicon on insulator (SOI) substrate.

In one or more embodiments, the waveguide 232, which is a silicon waveguide including Si, may include a rib waveguide or a channel waveguide. The first wiring insulating layer 2352 may have a refractive index less than that of the waveguide 232 and may include a cladding layer provided on and surrounding the waveguide 232. For example, the first wiring insulating layer 2352 may include silicon oxide. For example, the optical signals OS moving within the waveguide 232 may be totally reflected between the waveguide 232 and the first wiring insulating layer 2352.

The waveguide 232 may be connected to the optical component 230_P. The optical component 230_P may include individual devices configured to convert the optical signals OS into electrical signals and convert the electrical signals into the optical signals OS. In one or more embodiments, the optical component 230_P may include an optical detector, a light-emitting diode, and a modulator. For example, the light emitting diode may include a laser diode.

In the process of inputting the optical signals OS to the chip structure 200, the optical detector may detect the optical signals OS input to the PIC chip 230. The PIC chip 230 may detect the optical signals OS input through the optical detector and convert the optical signals OS into electrical signals.

In the process of outputting the optical signals OS by the chip structure 200, the EIC chip 220 may transmit the electrical signals to the modulator. The modulator may input signals corresponding to the electrical signals received from the laser emitted from the light-emitting diode and convert the laser emitted from the light-emitting diode into the optical signals OS.

The grating coupler 232_GC which is part of the waveguide 232 may be located on the active surface 231_A of the first substrate 231. The grating coupler 232_GC may include a portion of the outer surface of the waveguide 232, which is patterned in a grid shape. For example, the grating coupler 232_GC may be located at one end of the waveguide 232. When the optical signals OS are incident on the grating coupler 232_GC, the optical signals OS may move along the waveguide 232. For example, although the moving direction of the optical signals OS before the optical signals OS are incident on the grating coupler 232_GC is different from the extension direction of the waveguide 232, the moving direction of the optical signals OS may change into the extension direction of the waveguide 232 when the optical signals OS are incident on the grating coupler 232_GC.

The patterned surface GC_P of the grating coupler 232_GC may refer to a surface of the grating coupler 232_GC, on which a recessed pattern in a grid-shape is formed, of the outer surface of the grating coupler 232_GC. The non-patterned surface GC_UP of the grating coupler 232_GC which is opposite to the patterned surface GC_P of the grating coupler 232_GC may refer to a surface of the grating coupler 232_GC, on which a pattern is not formed, of the outer surface of the grating coupler 232_GC.

Referring to FIG. 6, the grating coupler 232_GC may include a recessed portion of the lower surface of the waveguide 232. For example, the patterned surface GC_P of the grating coupler 232_GC may include a lower surface of the grating coupler 232_GC, and the non-patterned surface GC_UP of the grating coupler 232_GC may include an upper surface of the grating coupler 232_GC.

The patterned surface GC_P of the grating coupler 232_GC may face downward in the vertical direction (Z direction) and the non-patterned surface GC_UP of the grating coupler 232_GC may face upward in the vertical direction (Z direction). For example, the patterned surface GC_P of the grating coupler 232_GC may face the EIC chip 220 and the first molding layer ML1 which are located below the PIC chip 230, and the non-patterned surface GC_UP of the grating coupler 232_GC may face the protective layer 240 located above the PIC chip 230.

In one or more embodiments, the PIC chip 230 may be placed on the EIC chip 220 so that the patterned surface GC_P of the grating coupler 232_GC faces the redistribution structure 210. For example, the patterned surface GC_P of the grating coupler 232_GC may not be exposed to the outside. For example, the patterned surface GC_P of the grating coupler 232_GC may not face the optical fiber 510.

In one or more embodiments, the non-patterned surface GC_UP of the grating coupler 232_GC may not be exposed to the outside. For example, the first wiring insulating layer 2352 and the first substrate 231 may be located above the non-patterned surface GC_UP of the grating coupler 232_GC. For example, the grating coupler 232_GC may be provided on and surrounded by the first wiring insulating layer 2352 and both the patterned surface GC_P and the non-patterned surface GC_UP of the grating coupler 232_GC may not be exposed to the outside.

The second reflector 234 may be located on the active surface 231_A of the first substrate 231. For example, the second reflector 234 may be located inside the first wiring insulating layer 2352. The second reflector 234 may reflect the optical signals OS.

The second reflector 234 may be configured so that the optical signals OS reflected from the second reflector 234 are incident on the grating coupler 232_GC.For example, the second reflector 234 may face the patterned surface GC_P of the grating coupler 232_GC.In one or more embodiments, the second reflector 234 may be located below the grating coupler 232_GC. For example, the distance between an upper surface of the second reflector 234 and a lower surface of the first wiring insulating layer 2352 in the vertical direction (Z direction) may be less than a distance between the patterned surface GC_P of the grating coupler 232_GC and the lower surface of the first wiring insulating layer 2352 in the vertical direction (Z direction). The vertical level of an upper surface of the second reflector 234 may be less than the vertical level of the patterned surface GC_P of the grating coupler 232_GC.

The second reflector 234 may overlap with the grating coupler 232_GC in the vertical direction (Z direction). For example, the second reflector 234 may completely overlap with the patterned surface GC_P of the grating coupler 232_GC. For example, an area of the upper surface of the second reflector 234 may be greater than an area of the patterned surface GC_P of the grating coupler 232_GC.

Referring to FIG. 7, the optical signals OS emitted from the optical fiber 510 may be reflected by the first reflector 233. The optical signals OS reflected from the first reflector 233 may pass through the interior of the first substrate 231 and may be incident on the grating coupler 232_GC. For example, since the first reflector 233 is located on the inactive surface 231_UA of the first substrate 231, which is the upper surface 231_U of the first substrate 231, the optical signals OS reflected from the first reflector 233 may be incident on the non-patterned surface GC_UP of the grating coupler 232_GC, which is the upper surface of the grating coupler 232_GC.

Some of the optical signals OS reflected from the first reflector 233 to the non-patterned surface GC_UP of the grating coupler 232_GC may move along the waveguide 232, and the others thereof may pass through the grating coupler 232_GC. Optical signals OS_P, that passed through the grating coupler 232_GC, of the optical signals OS incident on the grating coupler 232_GC may be incident on the second reflector 234. For example, the optical signals OS_P that passed through the grating coupler 232_GC may enter the non-patterned surface GC_UP of the grating coupler 232_GC and come out to the patterned surface GC_P of the grating coupler 232_GC. The optical signals OS_P that passed through the grating coupler 232_GC may be incident on the second reflector 234 that overlaps with the patterned surface GC_P of the grating coupler 232_GC.

The optical signals OS_P that passed through the grating coupler 232_GC may be reflected from the second reflector 234 and may be incident on the grating coupler 232_GC again. For example, the optical signals OS_P that passed through the grating coupler 232_GC may be reflected from the second reflector 234, may be incident on the patterned surface GC_P of the grating coupler 232_GC, and then may move along the waveguide 232.

In one or more embodiments, the PIC chip 230 may further include a shielding layer provided on and surrounding the outer surface of the second reflector 234. Interference between the second reflector 234 and the first wiring patterns 2351 may be suppressed through the shielding layer.

The process of transferring the optical signals OS from the optical component 230_P of the chip structure 200 to the optical fiber 510 may be the reverse of the process of transferring the optical signals OS from the optical fiber 510 to the chip structure 200, shown in FIG. 7.

In the chip structure 200, the optical signals OS emitted from the optical fiber 510 of the optical fiber unit 500 attached to the side surface of the chip structure 200 may be reflected by the first reflector 233 and the second reflector 234, and may be incident on the grating coupler 232_GC. Therefore, as the semiconductor package 1000 (see FIG. 2) including the chip structure 200 has the optical fiber unit 500 attached to the second side surface 200_S2 of the chip structure 200, a thickness of the semiconductor package 1000 (see FIG. 2) may be reduced in the vertical direction (Z direction).

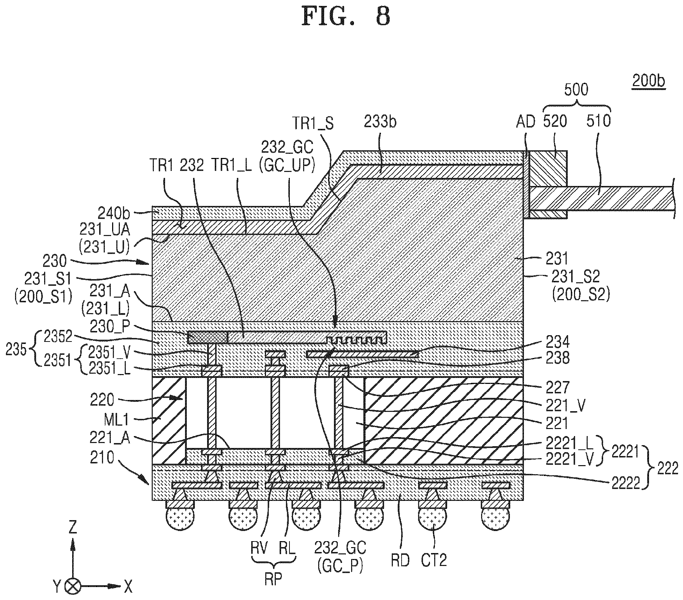

FIG. 8 is a schematic plan view of a chip structure 200b according to one or more embodiments.

Most of the components that form the chip structure 200b to be described below and the materials that make up the components are substantially the same as or similar to those described above with reference to FIG. 6. Therefore, for convenience of explanation, differences between the chip structure 200b of FIG. 8 and the chip structure 200 of FIG. 6 described above may be mainly described.

Referring to FIG. 8, the chip structure 200b may include a redistribution structure 210, an EIC chip 220, a first molding layer ML1, a PIC chip 230, and a protective layer 240b.

The PIC chip 230 may be located on the EIC chip 220 and the first molding layer ML1. The side surface of the PIC chip 230 may be coplanar with the side surface of the first molding layer ML1 and the side surface of the redistribution structure 210. The PIC chip 230 may include a first substrate 231, a first wiring structure 235, a waveguide 232, an optical component 230_P, a first reflector 233b, and a second reflector 234.

The first substrate 231 may include an active surface 231_A and an inactive surface 231_UA opposite to the active surface 231_A. The active surface 231_A of the first substrate 231 may face downward in the vertical direction (Z direction) and the inactive surface 231_UA of the first substrate 231 may face upward in the vertical direction (Z direction). The first wiring structure 235 may be located on the active surface 231_A of the first substrate 231, and the waveguide 232, the optical component 230_P, and the second reflector 234 may be located within the first wiring structure 235. The first reflector 233b may be located on the inactive surface 231_UA of the first substrate 231.

The first reflector 233b may be configured to reflect the optical signals reflected from the first reflector 233b to pass through the first substrate 231 and be incident on the non-patterned surface GC_UP of the grating coupler 232_GC. The second reflector 234 may be configured to reflect optical signals reflected from the second reflector 234 to be incident on the patterned surface GC_P of the grating coupler 232_GC. For example, the patterned surface GC_P of the grating coupler 232_GC may face downward in the vertical direction (Z direction) and the non-patterned surface GC_UP of the grating coupler 232_GC may face upward in the vertical direction (Z direction).

The first substrate 231 may include a first trench TR1. The first trench TR1 may be recessed inward from the upper surface 231_U of the first substrate 231 and may be exposed to the first side surface 231_S1 of the first substrate 231. For example, the first trench TR1 may be recessed inward from the upper surface 231_U and the first side surface 231_S1 of the first substrate 231. A portion of the upper surface 231_U of the first substrate 231 may define the bottom of the first trench TR1 and a portion of the upper surface 231_U of the first substrate 231 may define the side surface TR1_S of the first trench TR1. For example, a portion of the upper surface 231_U of the first substrate 231 that is not recessed inward may be referred to as a top surface of the first substrate 231.

The first reflector 233b may be conformally formed on the inactive surface 231_UA of the first substrate 231. For example, the first reflector 233b may be formed according to the shape of the inactive surface 231_UA of the first substrate 231. For example, the first reflector 233b may be conformally formed on the bottom TR1_L of the first trench TR1 of the first substrate 231, the side surface TR1_S of the first trench TR1, and the top surface of the first substrate 231. For example, the inactive surface 231_UA of the first substrate 231 may be covered entirely by the first reflector 233b. For example, the side surfaces of the first reflector 233b may be aligned with the side surfaces of the first substrate 231, respectively, in the vertical direction (Z direction).

The protective layer 240b may be located on the first reflector 233b. The protective layer 240b may be spaced apart from the first substrate 231 with the first reflector 233b in between the protective layer 240b and the first reflector 233b. The side surfaces of the protective layer 240b may be aligned with the side surfaces of the first reflector 233b and the side surfaces of the first substrate 231, respectively, in the vertical direction (Z direction).

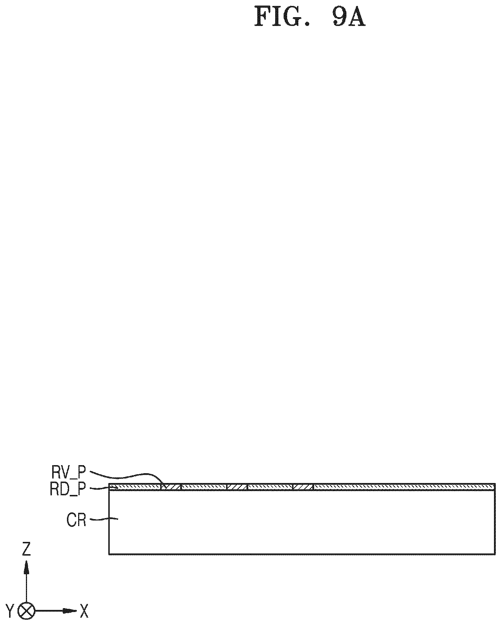

FIGS. 9A to 9H are diagrams illustrating a method of manufacturing the chip structure 200 according to one or more embodiments. FIGS. 9A to 9H are schematic diagrams illustrating the process of manufacturing the chip structure 200, based on the chip structure 200 of FIG. 6.

Referring to FIGS. 9A to 9H, the process of manufacturing the chip structure 200 includes mounting an EIC chip 220 on a carrier substrate CR, forming a first molding layer ML1 located on the carrier substrate CR, and provided on and surrounding the EIC chip 220, mounting a PIC chip 230 on the EIC chip 220 and the first molding layer ML1, forming a first trench TR1 on the first substrate 231 of the PIC chip 230, forming a first reflector 233 provided on and covering a side surface TR1_S of the first trench TR1, and forming a protective layer 240 provided on and covering the first reflector 233.

Referring to FIG. 9A, the carrier substrate CR may be prepared. For example, the carrier substrate CR may be in a wafer state before being diced into multiple dies. In one or more embodiments, preliminary pads RV_P and a preliminary insulating layer RV_D may be formed on an upper surface of the carrier substrate CR. Through the preliminary pads RV_P and the preliminary insulating layer RV_D, the alignment of the EIC chip 220 may be induced in the process of mounting the EIC chip 220 on the carrier substrate CR.

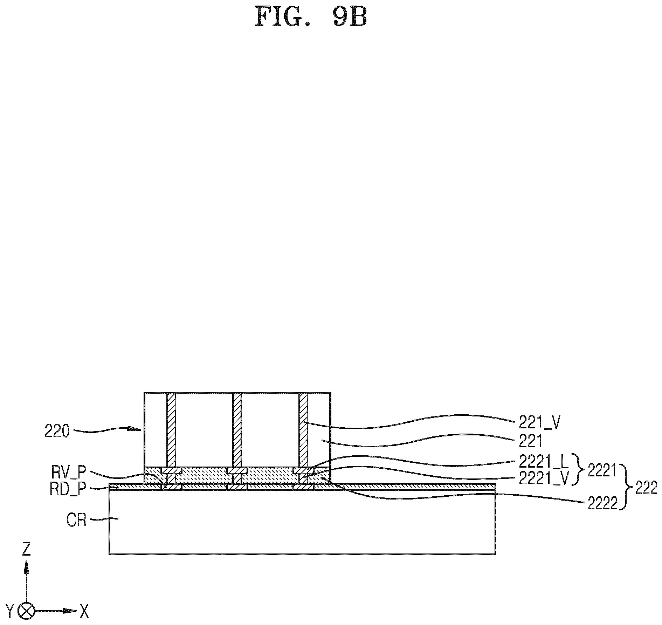

Referring to FIG. 9B, the EIC chip 220 may be mounted on the carrier substrate CR. The EIC chip 220 may include a second substrate 221, a second wiring structure 222, and second through vias 221_V. For example, the EIC chip 220 may be mounted on the carrier substrate CR so that the second wiring structure 222 of the EIC chip 220 faces the carrier substrate CR. For example, the EIC chip 220 may be mounted on the carrier substrate CR so that the active surface 221_A (see FIG. 3) of the second substrate 221 of the EIC chip 220 faces the carrier substrate CR.

In one or more embodiments, the EIC chip 220 may be mounted on the carrier substrate CR as the second wiring patterns 2221 of the second wiring structure 222 of the EIC chip 220 are diffusion bonded to the preliminary pads RV_P of the carrier substrate CR, respectively, and the second wiring insulating layer 2222 of the second wiring structure 222 of the IC chip 220 is diffusion bonded with the preliminary insulating layer RV_D of the carrier substrate CR.

However, embodiments are not limited thereto. When there are no preliminary pads RV_P and the preliminary insulating layer RV_D on the carrier substrate CR, the EIC chip 220 may be attached to the carrier substrate CR through a die attach film (DAF).

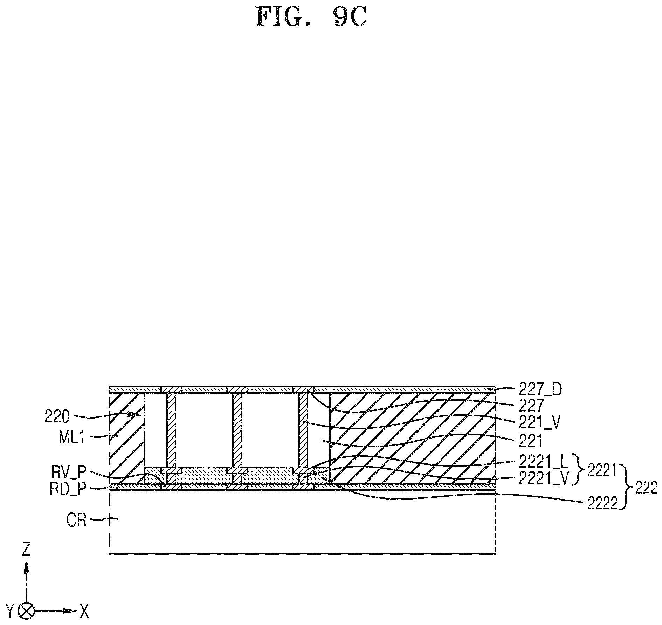

Referring to FIG. 9C, the first molding layer ML1, which is located on the carrier substrate CR, and provided on and surrounding the side surfaces of the EIC chip 220, may be formed. For example, the first molding layer ML1 may include epoxy resin or polyimide resin. The first molding layer ML1, for example, may include EMC.

In one or more embodiments, after forming the first molding layer ML1 to be provided on and cover the top of the EIC chip 220, the top of the first molding layer ML1 may be removed until the upper surface of the EIC chip 220 is exposed. The upper surface of EIC chip 220 may be coplanar with the upper surface of first molding layer ML1. In addition, the upper surfaces of the second through vias 221_V of the EIC chip 220 may be exposed to the outside.

Afterwards, the upper pads 227 and an upper insulating layer 227_D of the EIC chip 220 may be formed on the upper surface of the EIC chip 220. The upper insulating layer 227_D may be provided on and surround the side surfaces of the upper pads 227 of the EIC chip 220. The upper pads 227 of the EIC chip 220 may be electrically connected to the second through vias 221_V, respectively.

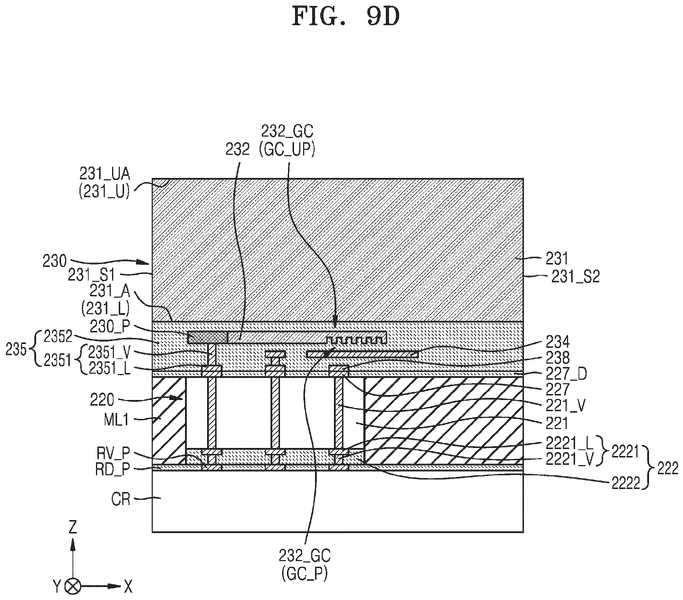

Referring to FIG. 9D, the PIC chip 230 may be mounted on the result of FIG. 9C. For example, the PIC chip 230 may be mounted on the result of FIG. 9C while the first substrate 231, the first wiring structure 235, the waveguide 232, the grating coupler 232_GC, the optical component 230_P, and the second reflector 234 are formed. For example, the grating coupler 232_GC, which is part of the waveguide 232, may include a portion of the lower surface of the waveguide 232, which is recessed in a grid shape.

In one or more embodiments, as the PIC chip 230 is manufactured based on an SOI substrate, the first substrate 231 may include a relatively thick silicon portion of the SOI substrate and the waveguide 232 may include a relatively thin silicon portion spaced apart from the first substrate 231 of the SOI substrate with an intermediate insulating layer in between. For example, the active surface 23 1_A of the first substrate 231 may include a portion facing the thin silicon portion, that is, a surface facing the waveguide 232. For example, the inactive surface 231_UA of the first substrate 231 may include a surface facing the active surface 23 1_A of the first substrate 231.

In one or more embodiments, the patterned surface GC_P of the grating coupler 232_GC may include a surface spaced apart from the intermediate insulating layer of the thin silicon portion of the SOI substrate. For example, the non-patterned surface GC_UP of the grating coupler 232_GC may face the active surface 231_A of the first substrate 231 and the patterned surface GC_P of the rating coupler 232_GC may be opposite to the non-patterned surface GC_UP of the grating coupler 232_GC.

The first wiring structure 235 may be located on the active surface 23 1_A of the first substrate 231. The waveguide 232, the second reflector 234, and the optical component 230_P may be located inside the first wiring structure 235.

The first wiring structure 235 may include first wiring patterns 2351 and a first wiring insulating layer 2352. The first wiring insulating layer 2352 may include the intermediate insulating layer described above. For example, in the process of forming the first wiring structure 235 on the SOI substrate, the intermediate insulating layer may form one body with the first wiring insulating layer 2352. The first wiring patterns 2351 may be connected to the optical component 230_P and may be connected to the upper pads 227 of the EIC chip 220, respectively. For example, the PIC chip 230 may be electrically connected to the EIC chip 220 through the first wiring patterns 2351.

In one or more embodiments, the PIC chip 230 may be mounted on the EIC chip 220 as the upper pads 227 of the EIC chip 220 are diffusion bonded with the lower pads 238 of the PIC chip 230 located at the bottom of the first wiring patterns 2351 of the PIC chip 230, respectively, and the first wiring insulating layer 2352 of the PIC chip 230 is diffusion bonded with the upper insulating layer 227_D of the EIC chip 220. However, embodiments are not limited thereto. The PIC chip 230 may be mounted on the EIC chip 220 through connection terminals, such as solder balls, or an adhesive film, such as an anisotropic conductive film (ACF).

For example, the PIC chip 230 may be mounted on the EIC chip 220 so that the active surface 231_A of the first substrate 231 faces downward in the vertical direction (Z direction), for example, toward the EIC chip 220. For example, the PIC chip 230 may be mounted on the EIC chip 220 so that the patterned surface GC_P of the grating coupler 232_GC of the PIC chip 230 faces downward in the vertical direction (Z direction), for example, toward the EIC chip 220 and the first molding layer ML1.

The second reflector 234 may be located inside the first wiring insulating layer 2352. For example, the second reflector 234 may be manufactured together in the process of manufacturing the first wiring line 2351_L of the first wiring structure 235. In one or more embodiments, a vertical level of the second reflector 234 may be equal to a vertical level of a portion of the first wiring line 2351_L. In one or more embodiments, materials of the second reflector 234 may be substantially the same as materials of the first wiring patterns 2351. For example, the second reflector 234 may include Cu, Al, Ag, Sn, Au, Ni, Pb, Ti, or alloys thereof.

The second reflector 234 may be located below the grating coupler 232_GC. For example, the distance between the upper surface of the second reflector 234 and a lower surface of the first wiring structure 235 in the vertical direction (Z direction) may be less than a distance between the patterned surface GC_P of the grating coupler 232_GC and the lower surface of the first wiring structure 235 in the vertical direction (Z direction). For example, the second reflector 234 may be configured reflect the optical signals reflected from the upper surface of the second reflector 234 to be incident on the patterned surface GC_P of the grating coupler 232_GC.

The second reflector 234 may overlap with the patterned surface GC_P of the grating coupler 232_GC in the vertical direction (Z direction). For example, the second reflector 234 may overlap with the entire patterned surface GC_P of the grating coupler 232_GC in the vertical direction (Z direction). For example, the area of the upper surface of the second reflector 234 may be greater than the area of the patterned surface GC_P of the grating coupler 232_GC.

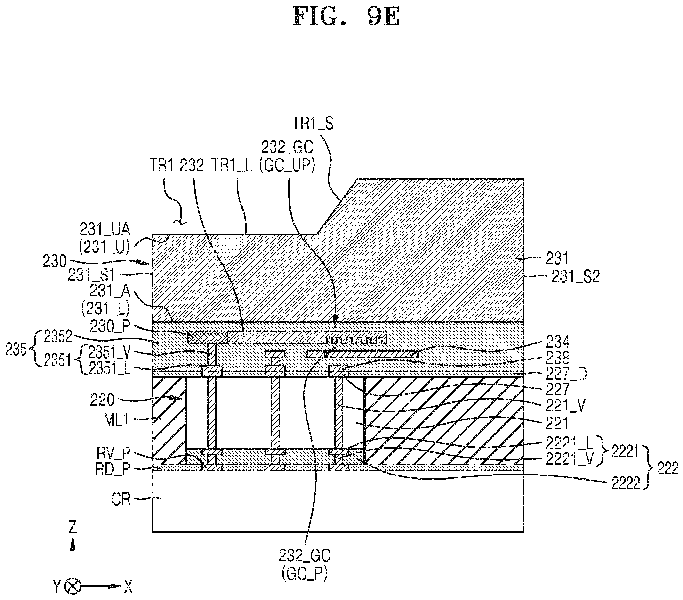

Referring to FIG. 9E, the first trench TR1 may be formed on the first substrate 231 of the PIC chip 230. The first trench TR1 may be recessed inward from the upper surface 231_U and first side surface 231_S1 of the first substrate 231. For example, a portion of the inactive surface 231_UA of the first substrate 231 may be removed. For example, the first trench TR1 may not completely pass through the first substrate 231.

A portion of the upper surface 231_U of the first substrate 231 may define the side surface TR1_S of the first trench TR1 and a portion of the upper surface 231_U of the first substrate 231 may define the bottom TR1_L of the first trench TR1. The angle formed between the side surface TR1_S of the first trench TR1 and the bottom TR1_L of the first trench TR1 may include an obtuse angle. For example, the first trench TR1 may be formed through a photo process.

In one or more embodiments, the angle formed between the side surface TR1_S of the first trench TR1 and the bottom TR1_L of the first trench TR1 may vary depending on the position of the grating coupler 232_GC. For example, as a distance between the grating coupler 232_GC and the second side surface 231_S2 of the first substrate 231 decreases, an angle formed between the side surface TR1_S of the first trench TR1 and the bottom TR1_L of the first trench TR1 may decrease.

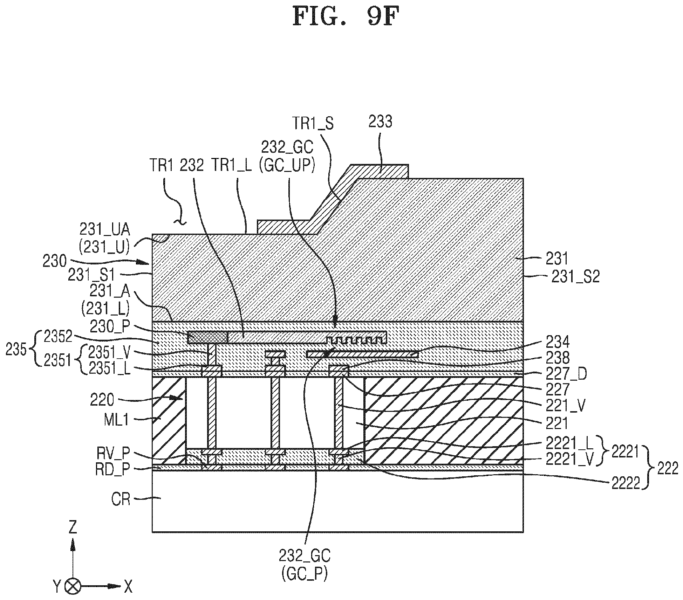

Referring to FIG. 9F, the first reflector 233 may be formed on the inactive surface 231_UA of the first substrate 231 of the PIC chip 230. The first reflector 233 may be formed on the side surface TR1_S of the first trench TR1 of the first substrate 231. For example, the first reflector 233 may be provided on and cover the top surface of the first substrate 231, a portion of the bottom TR1_L of the first trench TR1, and the side surface TR1_S of the first trench TR1. For example, a portion of the inactive surface 231_UA of the first substrate 231 may not contact the first reflector 233. For example, the first reflector 233 may have a "Z" shape.

The first reflector 233 may be configured to reflect the optical signals reflected from the first reflector 233 to be incident on the grating coupler 232_GC. In one or more embodiments, the optical signals incident on the side surface TR1_S of the first trench TR1 may be reflected from the first reflector 233 and may be incident on the non-patterned surface GC_UP of the grating coupler 232_GC. For example, the first reflector 233 may include Cu, Al, Ag, Sn, Au, Ni, Pb, Ti, or alloys thereof.

In one or more embodiments, the optical signals reflected from the first reflector 233 may be incident on the upper surface of the grating coupler 232_GC. One or more of the optical signals, incident on the upper surface of the grating coupler 232_GC, may move along the waveguide 232, and the others thereof may pass through the grating coupler 232_GC and may be incident on the second reflector 234. The optical signals incident on the second reflector 234 may be reflected by the second reflector 234, may be incident on the lower surface of the grating coupler 232_GC, and may move along the waveguide 232.

For example, after forming the first reflector 233 conformally on the inactive surface 231_UA of the first substrate 231 of the PIC chip 230, a portion of the first reflector 233 may be removed through an etching process. However, embodiments are not limited thereto. The process of removing a portion of the first reflector 233 may be omitted.

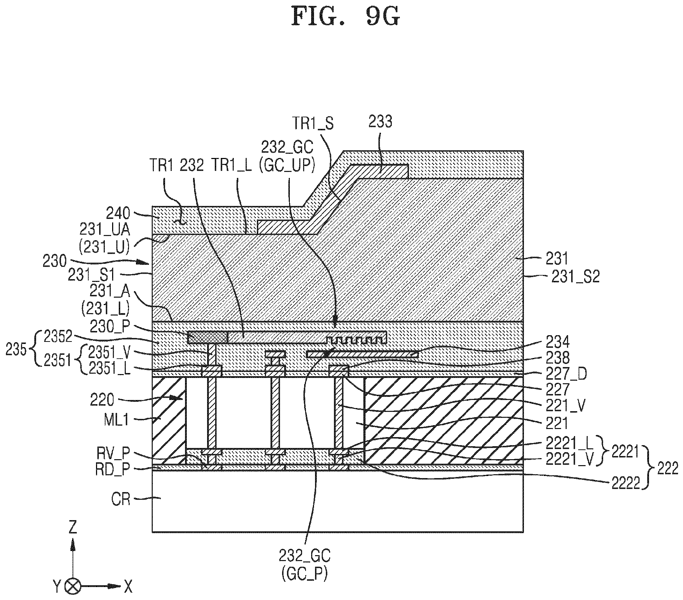

Referring to FIG. 9G, the protective layer 240 may be formed on the inactive surface 231_UA of the first substrate 231. The protective layer 240 may be formed conformally on the upper surface of the result of FIG. 9F. The protective layer 240 may be provided on and cover the first reflector 233. For example, the protective layer 240 may be conformally formed on the inactive surface 231_UA of the first substrate 231 and the first reflector 233. In one or more embodiments, the protective layer 240 may include silicon oxide.

In one or more embodiments, the process of manufacturing the chip structure 200 may further include forming the redistribution structure 210. The redistribution structure 210 may be located on the EIC chip 220. In one or more embodiments, after forming the protective layer 240, the EIC chip 220 may be removed from the carrier substrate CR, and the redistribution structure 210 may be formed on the EIC chip 220. In one or more embodiments, after the redistribution structure 210 is formed on the carrier substrate CR, the EIC chip 220 may be mounted on the redistribution structure 210.

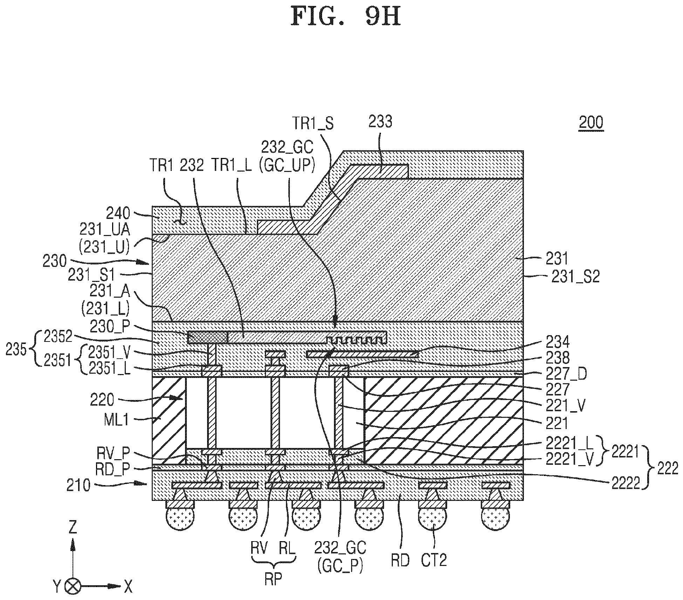

Referring to FIG. 9H, the EIC chip 220 may be removed from the carrier substrate CR and the redistribution structure 210 may be formed on the EIC chip 220. For example, the redistribution patterns RP of the redistribution structure 210 may be electrically connected to the preliminary pads RV_P, respectively, and the redistribution insulating layer RD may be in contact with the preliminary insulating layer RV_D. For example, the preliminary pads RV_P may be referred to as the redistribution patterns RP of the redistribution structure 210, and the preliminary insulating layer RV_D may be referred to as the redistribution insulating layer RD. In one or more embodiments, the connection terminals CT2 may be attached to the lower surface of the redistribution structure 210.

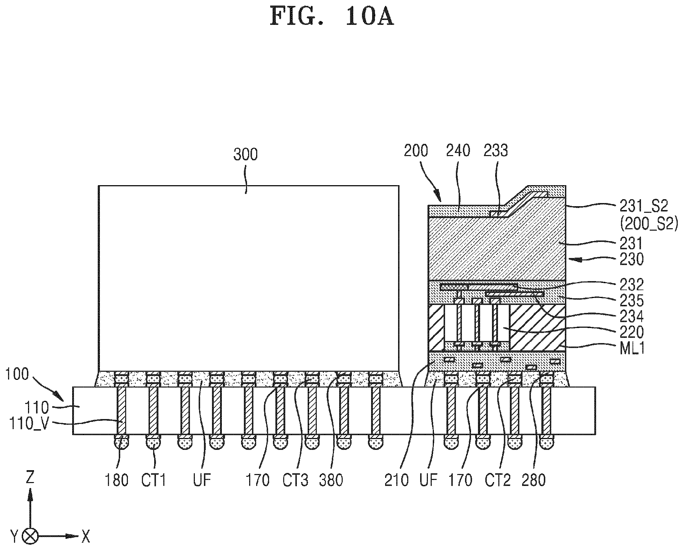

FIGS. 10A to 10E are diagrams illustrating a method of manufacturing a semiconductor package 1000b according to one or more embodiments. FIGS. 10A to 10E disclose the process of manufacturing the semiconductor package 1000b including the chip structure 200 manufactured based on the manufacturing process described with reference to FIGS. 9A to 9H.

Referring to FIGS. 10A to 10E, the method of manufacturing the semiconductor package 1000b may include manufacturing the chip structure 200, mounting the semiconductor chip 300 and the chip structure 200 on the package substrate 100, mounting the chip structure 200 and the semiconductor chip 300 on the package substrate 100, and forming the second molding layer ML2 on the package substrate 100.

The manufacturing of the chip structure 200 during the method of manufacturing the semiconductor package 1000b may be substantially the same as the method of manufacturing the chip structure 200 described with reference to FIGS. 9A to 9H. For example, FIGS. 10A to 10E disclose the method of manufacturing the semiconductor package 1000b including the chip structure 200 and other chips after manufacturing the chip structure 200.

Referring to FIG. 10A, the chip structure 200 and the semiconductor chip 300 may be mounted on the package substrate 100. For example, the package substrate 100 may include an interposer including the substrate 110 and the through vias 110_V passing through the substrate 110. For example, the package substrate 100 may electrically connect the chip structure 200 to the semiconductor chip 300, each mounted on the package substrate 100.

In FIG. 10A, it is shown that the semiconductor chip 300 and the chip structure 200 are mounted on the package substrate 100, but is not limited thereto. Instead of the semiconductor chip 300, the stacked structure 400 (see FIG. 2) may be mounted on the package substrate 100. In addition, the stacked structure 400 (see FIG. 2), the semiconductor chip 300, and the chip structure 200 may all be mounted on the package substrate 100.

In one or more embodiments, the chip structure 200 may be mounted on the package substrate 100 through the connection terminals CT2, and the semiconductor chip 300 may also be mounted on the package substrate 100 through the connection terminals CT3. However, embodiments are not limited thereto. The chip structure 200 and the semiconductor chip 300 may be mounted on the package substrate 100 through an adhesive film, such as an anisotropic adhesive film, or hybrid bonding.

Afterwards, the underfill layer UF may be formed between the chip structure 200 and the package substrate 100 and between the semiconductor chip 300 and the package substrate 100 through an underfill process. The underfill layer UF may be provided on and cover the connection terminals CT2 located between the chip structure 200 and the package substrate 100, and the connection terminals CT3 located between the semiconductor chip 300 and the package substrate 100.

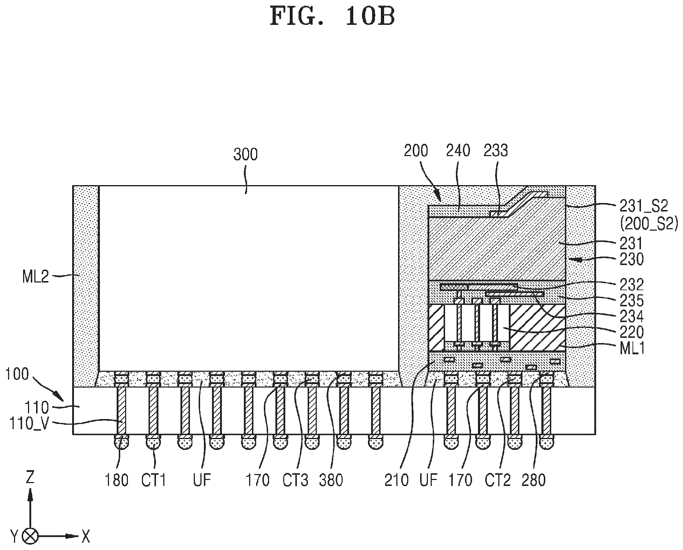

Referring to FIG. 10B, the second molding layer ML2 located on the package substrate 100, and provided on and surrounding the chip structure 200 may be formed. The second molding layer ML2 may be applied onto the package substrate 100 to be provided on and cover all components located on the package substrate 100.

For example, The second molding layer ML2 located on the package substrate 100 may be applied to the package substrate 100 to be provided on and cover the semiconductor chip 300 and the chip structure 200. Afterwards, a portion of the second molding layer ML2 may be removed until the upper surface of the chip structure 200 and the upper surface of the package substrate 100 are exposed to the outside. Accordingly, the upper surface of the second molding layer ML2, the upper surface of the semiconductor chip 300, and a portion of the upper surface of the chip structure 200 may be coplanar.

In one or more embodiments, a portion of the second molding layer ML2 may be located inside the first trench TR1 (see FIG. 6) of the first substrate 231 of the PIC chip 230 of the chip structure 200. In one or more embodiments, there may be an interface between the second molding layer ML2 and the first molding layer ML 1 of the chip structure 200. For example, although materials of the first molding layer ML1 and the second molding layer ML2 may be the same, there may be an interface between the first molding layer ML1 and the second molding layer ML2 because the curing time of the first molding layer ML1 is different from the curing time of the second molding layer ML2.

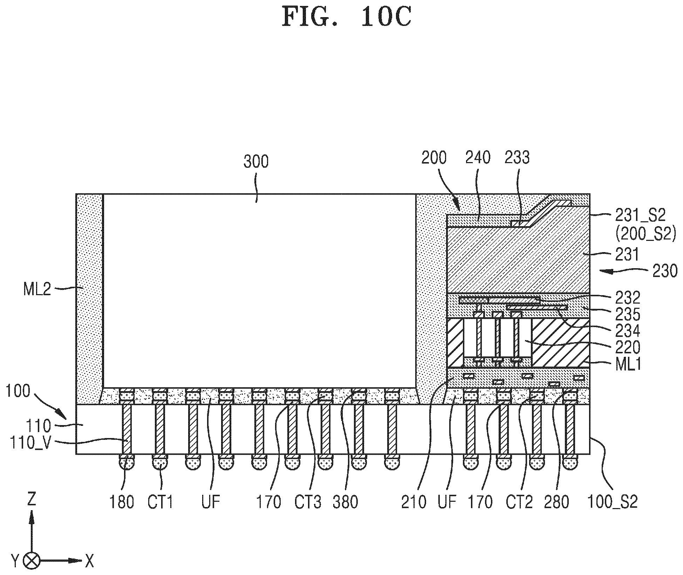

Referring to FIG. 10C, one side surface of the chip structure 200 may be exposed to the outside by sawing the result of FIG. 10B.

For example, the second molding layer ML2 and the package substrate 100 may be cut so that one side surface of the chip structure 200 is exposed. The exposed side surface of the chip structure 200 may include the second side surface 200_S2 of the chip structure 200. Among the side surfaces of the package substrate 100, a cut surface may include the second side surface 100_S2 of package substrate 100. The second side surface 200_S2 of the chip structure 200 may be coplanar with the second side surface 100_S2 of the package substrate 100.

In one or more embodiments, in the process of cutting the second molding layer ML2 and the package substrate 100, a portion of the underfill layer UF located below the chip structure 200 may be cut together. Accordingly, one side surface of the underfill layer UF located between the chip structure 200 and the package substrate 100 may be coplanar with the second side surface 200_S2 of the chip structure 200 and the second side surface 100_S2 of the package substrate 100.

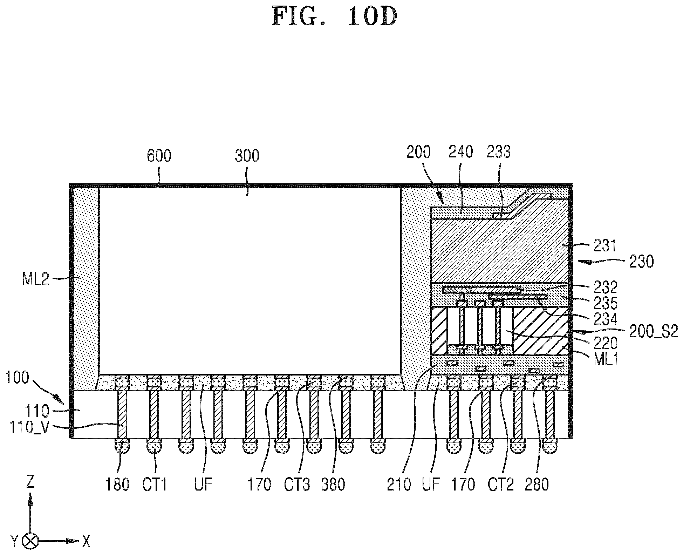

Referring to FIG. 10D, the anti-reflective layer 600 may be formed on the outer surface of the result of FIG. 10C. The anti-reflective layer 600 may be deposited on the outer surface of the result of FIG. 10C by chemical vapor deposition. The anti-reflective layer 600 may be formed on the second side surface 200_S2 of the chip structure 200 and the outer surface of the second molding layer ML2.

The refractive index of the anti-reflective layer 600 may be less than the refractive index of the first substrate 231. For example, the refractive index of the anti-reflective layer 600 may be between the refractive index of the first substrate 231 of the PIC chip 230 and a refractive index of the core layer of the optical fiber 510 of the optical fiber unit 500. The anti-reflective layer 600 may improve the accuracy of transmission of optical signals between the optical fiber 510 and the PIC chip 230.

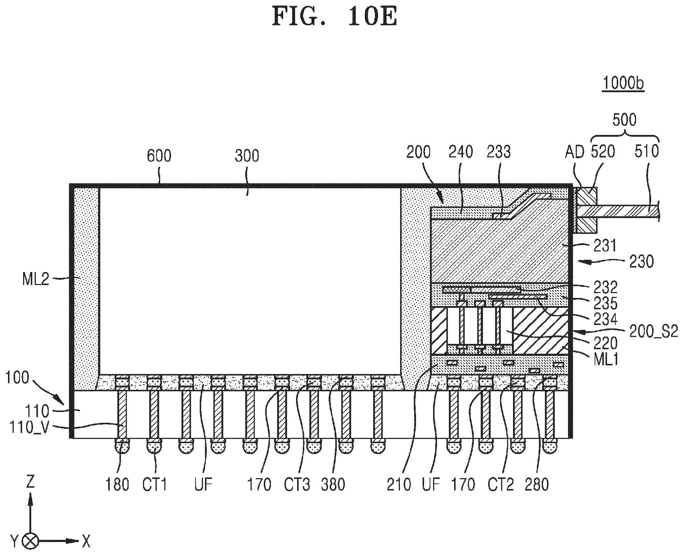

Referring to FIG. 10E, the optical fiber unit 500 may be attached to the result of FIG. 10D. For example, the optical fiber unit 500 may be attached to the second side surface 200_S2 of the chip structure 200 through the optical adhesive film AD or the optical fiber unit 500 may be detachably attached to the chip structure 200.

The optical fiber unit 500 may include a frame 520 and an optical fiber 510 fixed to the frame 520. The optical fiber unit 500 may be attached to the chip structure 200 so that the optical signals emitted from the optical fiber 510 are directed to the first reflector 233 of the PIC chip 230 of the chip structure 200.

Although the optical fiber unit 500 is attached to the chip structure 200, a thickness of the semiconductor package 1000b may not increase in the vertical direction (Z direction) because the optical fiber unit 500 may be attached to the second side surface 200_S2 of the chip structure 200.

While embodiments have been described with reference to the figures, it will be understood by those of ordinary skill in the art that various changes in form and details may be made therein without departing from the scope as defined by the following claims.

## Claims

1. A chip structure comprising:
a redistribution structure (210);
an electronic integrated circuit chip (220) on an upper surface of the redistribution structure (210); and
a photonic integrated circuit chip (230, 230a) comprising:
a first substrate (231) on an upper surface of the electronic integrated circuit chip (220) and comprising an active surface (231_A) and an inactive surface (231_UA) opposite to the active surface (231_A);
a first reflector (233, 233b) on the inactive surface (231_UA) of the first substrate (231); and
a first wiring structure (235) on the active surface (231_A) of the first substrate (231), the first wiring structure (235) comprising a waveguide (232), a grating coupler (232_GC), and a second reflector (234),
wherein a patterned surface (GC_P) of the grating coupler (232_GC) faces the redistribution structure (210).

2. The chip structure of claim 1, wherein the first reflector (233, 233b) is configured to reflect optical signals reflected from the first reflector (233, 233b) to be incident on a non-patterned surface (GC_UP) of the grating coupler (232_GC) opposite to the patterned surface (GC_UP) of the grating coupler (232_GC), and
wherein the second reflector (234) is configured to reflect optical signals reflected from the second reflector (234) to be incident on the patterned surface (GC_UP) of the grating coupler (232_GC).

3. The chip structure of claim 2, wherein the photonic integrated circuit chip (230) is configured to transmit a portion of the optical signals, which are reflected from the first reflector (233, 233b) included in the photonic integrated circuit chip (230) and are incident on the non-patterned surface (GC_UP) of the grating coupler (232_GC), to pass through the grating coupler (232_GC) and be incident on the second reflector (234).

4. The chip structure of any one of claims 1 to 3, wherein the second reflector (234) is on the grating coupler (232_GC) of the photonic integrated circuit chip (230), and
wherein the patterned surface (GC_UP) of the grating coupler (232_GC) faces an upper surface of the second reflector (234) of the photonic integrated circuit chip (230).

5. The chip structure of claim 4, wherein an area of the patterned surface (GC_UP) of the grating coupler (232_GC) is less than an area of the upper surface of the second reflector (234).

6. The chip structure of any one of claims 1 to 5, wherein the first wiring structure (235) further comprises a first wiring insulating layer (2352) on the waveguide (232), the grating coupler (232_GC), and the second reflector (234),
wherein side surfaces of the first wiring insulating layer (2352) are aligned with side surfaces of the first substrate (231) in a vertical direction, and
wherein a refractive index of the first wiring insulating layer (2352) is less than a refractive index of the waveguide (232).

7. The chip structure of claim 6, wherein the grating coupler (232_GC) is spaced apart from the second reflector (234) in the vertical direction, and the first wiring insulating layer (2352) is between the grating coupler (232_GC) and the second reflector (234).

8. The chip structure of any one of claims 1 to 7, wherein the first substrate (231) comprises a first trench (TR1) which is recessed inward from an upper surface (231_U) of the first substrate (231) and exposed to a first side surface (231_S1) among side surfaces of the first substrate (231), and
wherein an angle between a portion of the upper surface (231_U) of the first substrate (231) forming a side surface (TR1_S) of the first trench (TR1) and a portion of the upper surface (231_U) of the first substrate (231) forming a bottom surface of the first trench (TR1) is an obtuse angle.

9. The chip structure of claim 8, wherein the angle between the side surface (TR1_S) of the first trench (TR1) of the first substrate (231) and the bottom surface of the first trench (TR1) of the first substrate (231) is 110 degrees to 150 degrees.

10. The chip structure of claim 8 or 9, wherein a portion of the first reflector (233, 233b) is on the side surface (TR1_S) of the first trench (TR1) of the first substrate (231).

11. The chip structure of any one of claims 8 to 10, further comprising a protective layer (240, 240b) on the upper surface of the first substrate (231) and the first reflector (233, 233b).

12. The chip structure of any one of claims 8 to 11, wherein the first reflector (233, 233b) is on the upper surface (231_U) of the first substrate (231), and
wherein side surfaces of the first reflector (233, 233b) are aligned with the side surfaces of the first substrate (231) in a vertical direction.

13. The chip structure of any one of claims 1 to 12, wherein an area of a lower surface of the electronic integrated circuit chip (220) is less than an area of a lower surface of the photonic integrated circuit chip (230),
wherein the chip structure (200, 200a, 200b) further comprises a first molding layer (ML1) between the redistribution structure (210) and the photonic integrated circuit chip (230) and on the electronic integrated circuit chip (220), and
wherein side surfaces of the first molding layer (ML1) are aligned with side surfaces of the photonic integrated circuit chip (230) in a vertical direction (Z).

14. A semiconductor package comprising:
a package substrate (100);
a semiconductor chip (300) on the package substrate (100); and
a chip structure (200, 200a, 200b) on the package substrate (100) and spaced apart from the semiconductor chip (300) in a horizontal direction,
wherein the chip structure (200, 200a, 200b) is according to any one of claims 1 to 13.

15. The semiconductor package according to claim 14, further comprising:
a second molding layer (ML2) on the package substrate (100), the semiconductor chip (300), and the chip structure (200, 200a, 200b), wherein side surfaces of the second molding layer (ML2) are aligned with side surfaces of the package substrate (100) in a vertical direction, and wherein an upper surface of the second molding layer (ML2) is coplanar with an upper surface of the chip structure (200, 200a, 200b) and an upper surface of the semiconductor chip (300); and
an optical fiber unit (500) on a side surface of the chip structure (200, 200a, 200b), the optical fiber unit (500) comprising an optical fiber (510) configured to emit optical signals to the first reflector (233, 233b) of the chip structure (200, 200a, 200b).
